**Europäisches Patentamt**

**European Patent Office**

**Office européen des brevets**

(11) Veröffentlichungsnummer: **0 163 315**
**A2**

## (12) EUROPÄISCHE PATENTANMELDUNG

(21) Anmeldenummer: 85106719.9

(22) Anmeldetag: 31.05.85

(51) Int. Cl.⁴: **B 29 C 43/18**
B 29 C 67/18, B 32 B 31/20
//B29L9:00

(30) Priorität: 01.06.84 DE 3420429

(43) Veröffentlichungstag der Anmeldung:
04.12.85 Patentblatt 85/49

(84) Benannte Vertragsstaaten:
AT BE CH DE FR GB IT LI NL SE

(71) Anmelder: ELTI Apparatebau und Elektronik GmbH
Am Dornbusch 17-19
D-6106 Erzhausen(DE)

(71) Anmelder: HOECHST AKTIENGESELLSCHAFT
Postfach 80 03 20
D-6230 Frankfurt am Main 80(DE)

(72) Erfinder: Kühnert, Hans-Günter Egbert
Lerchenweg 8
D-6106 Erzhausen(DE)

(74) Vertreter: Zounek, Nikolai, Dipl.-Ing. et al,
c/o KALLE Niederlassung der Hoechst AG
Patentabteilung Postfach 3540
Rheingaustrasse 190 D-6200 Wiesbaden 1(DE)

(54) Verfahren zum Laminieren eines Films unter Druck und Wärme und Vorrichtung zur Durchführung des Verfahrens.

(57) Verfahren zum Laminieren eines Films unter Druck und Wärme und Vorrichtung zur Durchführung des Verfahrens.

Ein Schichtträger, wie beispielsweise eine Leiterplatte, eine Multilayerschicht, eine Metallplatte oder eine Trägerschicht mit beidseitig aufgebrachten Metallschichten wird in horizontaler Lage in einer Heizstation beidseitig flächendeckend beheizt und auf einen vertikal auf Saugplatten von Vakuumtischen aufgespannten Fotoresistfilm geführt, der eine zwischen den Vakuumtischen angeordnete Laminierstation mitüberspannt. Der Fotoresistfilm wird von einer einzigen Vorratsrolle mittels einer Greiferleiste abgezogen und über die Vakuumtische und die Laminierstation geführt. Eine Schneideinrichtung schneidet den Fotoresistfilm quer zu seiner Längsrichtung durch. Der Schichtträger berührt den Fotoresistfilm auf der Höhe der Laminierstation, so daß der weitertransportierte Schichtträger in den Spalt zwischen den rotierenden Laminierwalzen der Laminiervorrichtung eingeschoben, von diesen erfaßt und zusammen mit dem Fotoresistfilm, der sich auf die Ober- und Unterseite des Schichtträgers anlegt, durch die Laminierstation hindurchtransportiert wird.

./...

FIG.4

E L T I Apparatebau und Elektronik GmbH
und
H O E C H S T   A K T I E N G E S E L L S C H A F T
KALLE  Niederlassung der Hoechst AG

84/K 753                  - 1 -              21. Mai 1985
                                            WLK-DI.Z.-is


Verfahren zum Laminieren eines Films unter Druck und
Wärme und Vorrichtung zur Durchführung des Verfahrens

Die Erfindung betrifft ein Verfahren zum Laminieren eines Films unter Druck und Wärme auf die sich gegenüberliegenden Seiten eines Schichtträgers, dessen beiden Seiten erwärmt sind, und eine Vorrichtung zum Durchführen dieses Verfahrens.

Es handelt sich dabei um ein Verfahren zum Aufbringen eines gleichmäßigen Films aus Fotoresistmaterial auf die beiden Seiten eines Schichtträgers, der beispielsweise eine metallische Platte oder ein Trägerkörper mit auf beiden Seiten aufgedampften und/oder geklebten Metallschichten ist.

Aus den offengelegten europäischen Patentanmeldungen 0 040 842, 0 040 843 und 0 041 642 sind Laminierverfahren bekannt, bei denen ein Substrat bzw. ein Schichtträger beidseitig unter Druckanwendung mit einem Trockenresist laminiert wird. Der Trockenresist wird für die jeweilige zu laminierende Seite des Schichtträgers, beispielsweise eine Leiterplatte, von einer Vorratsrolle abgezogen und einem Paar von Laminierwalzen zugeführt, durch deren Spalt die beiden Trockenresistfilme und der dazwischen befindliche Schichtträger hindurchlaufen. Vor dem Laminieren wird auf die Oberfläche des Schichtträgers bzw. der Leiterplatte eine dünne Flüssigkeitsschicht aufgebracht, die eine Zwischenschicht zwischen der Oberfläche der Lei-

E L T I Apparatebau und Elektronik GmbH
und
H O E C H S T   A K T I E N G E S E L L S C H A F T
KALLE  Niederlassung der Hoechst AG

0163315

- 2 -

terplatte und dem jeweiligen Trockenresistfilm während
des Laminiervorgangs bildet. Diese dünne Flüssigkeitsschicht wird von der Oberfläche der Leiterplatte durch
Absorption in den Trockenresistfilm während des Laminierens entfernt.

Die US-PS 4,214,936 betrifft ein Laminierverfahren,
bei dem horizontal transportierte Platten, die kontinuierlich vorwärtsbewegt und kontaktbeheizt werden,
beidseitig laminiert werden, wobei die Umfangsgeschwindigkeit der Laminierwalzen größer als die Vorschubgeschwindigkeit der Platten ist. Sobald ein Sensor die Hinterkante der vorgeheizten Platte kurz vor
ihrem Eintritt in den Spalt zwischen den Laminierwalzen feststellt, werden diese erst nach einer gewissen
Verzögerungszeit gestoppt, die es ermöglicht, daß die
Hinterkante der Platte den Laminierspalt passiert. Sobald die Vorderkante der nachfolgenden Platte festgestellt wird, beginnen die Laminierwalzen von neuem zu
rotieren und die in den Spalt eintretende Platte wird
laminiert. Dieser Vorgang wird für jede neue Platte
wiederholt, und somit wird ein gleichbleibender Abstand zwischen den einzelnen laminierten Platten nach
dem Spalt erhalten. Es entsteht somit ein zusammenhängendes Band aus zwei Trockenresistschichten, zwischen
denen jeweils im gleichen Abstand die Platten eingeschlossen sind. Die Verbindungslänge der Resistschichten zwischen zwei Platten beträgt beispielsweise
18 mm.

E L T I Apparatebau und Elektronik GmbH
und
H O E C H S T   A K T I E N G E S E L L S C H A F T
KALLE Niederlassung der Hoechst AG

- 3 -

Bei den bekannten Laminierverfahren werden die Trockenresistfilme, die auf die Platte auflaminiert werden,
stets von zwei Vorratsrollen der Laminierstation zugeführt, so daß für die Vorratshaltung der Trockenresistfilme ein doppelter Aufwand erforderlich ist. Von
Nachteil ist des weiteren bei dem Laminierverfahren
nach der US-Patentschrift, daß ein verhältnismäßig
großer Abfall an Trockenresist entsteht, da die einzelnen Platten über Verbindungsstücke aus Trockenresist zusammenhängen und diese Verbindungsstücke durch-
und abgeschnitten werden müssen, um die einzelne
laminierte Platte weiterverarbeiten zu können. Durch
die Verbindungsstücke zwischen den einzelnen Platten
ist ein gleichmäßiges Auflaminieren auf die einzelne
Platte im Übergangsbereich von der Platte zu den Verbindungsstücken nicht sichergestellt, so daß nach dem
Durchschneiden der Verbindungsstücke unter Umständen
der Fall eintreten kann, daß sich der Fotoresist im
Randbereich der Platte löst.

Aufgabe der Erfindung ist es, ein Verfahren und eine
Vorrichtung zum Laminieren eines Films, wie beispielsweise eines Fotoresistfilms, auf einen Schichtträger
zu schaffen, die ein gleichmäßiges, beidseitiges faltenfreies Auflaminieren des Fotoresists auf die beiden
Seiten des Schichtträgers bei sehr geringen Verlusten
durch Fotoresistverschnitt ermöglichen.

Diese Aufgabe löst erfindungsgemäß ein Verfahren, das
durch folgende Schritte gekennzeichnet ist:

E  L  T  I  Apparatebau und Elektronik GmbH
und
H O E C H S T  A K T I E N G E S E L L S C H A F T
KALLE  Niederlassung der Hoechst AG

- 4 -

(a) der Schichtträger wird in waagerechter Lage beidseitig flächendeckend beheizt,

(b) eine vorbestimmte Länge des Films wird von einer einzelnen Vorratsrolle abgezogen, senkrecht über die Oberseite von vertikal ausgerichteten Vakuumtischen und einer dazwischen befindlichen Laminierstation geführt und mit Hilfe der Vakuumtische senkrecht aufgespannt,

(c) der Film wird im Bereich zwischen der oberen Kante des über der Laminierstation angeordneten Vakuumtisches und der Laminierstation durchschnitten,

(d) der aufgeheizte, waagerecht transportierte Schichtträger wird auf den senkrecht aufgespannten Film in Höhe der Laminierstation geführt,

(e) der Schichtträger zieht beim Einschieben in die Laminierstation den Film in den Spalt zwischen zwei Laminierwalzen, die rotieren und den Verbund aus Schichtträger und dem sich gleichzeitig auf die sich gegenüberliegenden Seiten des Schichtträgers anlegenden Film horizontal hindurchtransportieren, wobei der Film unter Druckkontakt auf die beiden Seiten des Schichtträgers laminiert wird.

Die weitere vorteilhafte Ausgestaltung des Verfahrens ergibt sich aus den Merkmalen der Patentansprüche 2 bis 9.

E L T I Apparatebau und Elektronik GmbH
und
H O E C H S T   A K T I E N G E S E L L S C H A F T
KALLE  Niederlassung der Hoechst AG

- 5 -

Die Vorrichtung zur Durchführung des Verfahrens, mit einer Vorratsrolle aus Fotoresist als Film, einem Magazin für die Aufnahme der zu laminierenden Schichtträger, einer Heizstation für die Schichtträger, einer Laminierstation aus zwei Laminierwalzen und Vakuumtischen zum Aufspannen des Fotoresists sowie einer Schneideinrichtung zum Schneiden des Fotoresists ist dadurch gekennzeichnet, daß der Schichtträger horizontal über eine Rollenbahn durch eine Heizstation, eine Ausrichtvorrichtung und einen Plattengreifer hindurchläuft und mit der Vorderkante an einem Parallelanschlag zum Anliegen kommt, der in die Rollenbahn einschwenkbar und aus dieser ausschwenkbar ist, daß oberhalb und unterhalb der Laminierstation je ein Vakuumtisch mit vertikaler Saugplatte angeordnet ist und daß eine Greiferleiste einen streifenförmigen Abschnitt des Fotoresistfilms ergreift und entlang zueinander paralleler, vertikaler Führungsstangen vertikal nach unten aus einer einstellbaren Stellung oberhalb der Laminierstation, über die Laminierstation hinweg bis in eine Stellung im Bereich des unteren Vakuumtisches verfährt.

Die weitere vorteilhafte Ausgestaltung der Vorrichtung ergibt sich aus den Merkmalen der dem Patentanspruch 10 folgenden Ansprüche.

Im folgenden wird anhand der Zeichnungen die Erfindung näher erläutert.

E  L  T  I  Apparatebau und Elektronik GmbH
und
H O E C H S T   A K T I E N G E S E L L S C H A F T
KALLE  Niederlassung der Hoechst AG

- 6 -

Es zeigen:

Fig. 1    eine schematische Explosionsdarstellung der
          einzelnen Stationen der Vorrichtung nach der
          Erfindung,

Fig. 2    eine Seitenansicht des wesentlichen Teils der
          Vorrichtung,

Fig. 3    eine Draufsicht auf den Teil nach Fig. 2,

Fig. 4    eine perspektivische Ansicht der Vakuumtische
          mit den dazu gehörenden Einrichtungen sowie
          der Laminierstation,

Fig. 5    ein schematisches Bild der Laminierstation
          sowie der Greifer- und Transporteinrichtungen
          für den Schichtträger, die in Transportrichtung des Schichtträgers gesehen vor der Laminierstation angeordnet sind, und

Fig. 6    eine perspektivische Ansicht der in Fig. 5
          schematisch dargestellten Bauteile und
          Einrichtungen,

Fig. 7a,b,c,d verschiedene Ausgestaltungen von Saugplatten der Vakuumtische,

Fig. 8    eine schematische Ansicht einer Heizvorrichtung
          zum Erwärmen der Schichtträger, und

E  L  T  I  Apparatebau und Elektronik GmbH
und
H O E C H S T   A K T I E N G E S E L L S C H A F T
KALLE  Niederlassung der Hoechst AG

0163315

- 7 -

Fig. 9a und b eine perspektivische Teilansicht und eine
Seitenansicht einer Schneideinrichtung zum
Durchtrennen des Fotoresistfilms.

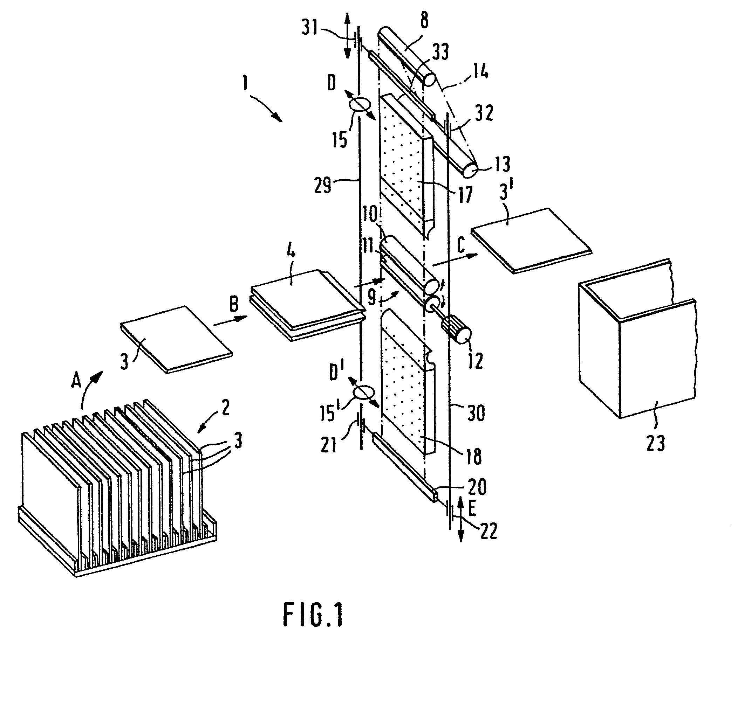

Eine in Fig. 1 schematisch dargestellte Laminiervorrichtung 1 enthält in einem Vorratsmagazin 2 Schichtträger 3, wie beispielweise Leiterplatten, Multilayerschichten, Metallplatten oder dgl., auf die ein Fotoresistfilm 14 beidseitig auflaminiert werden soll. In
dem Vorratsmagazin 2 wird der Schichtträger 3 erfaßt
und in Richtung des Pfeils A horizontal verschwenkt
und auf einer nicht gezeigten Rollenbahn in Richtung
des Pfeils B in eine Heizstation 4 transportiert. Der
Aufbau und die Funktionsweise der Heizstation 4 werden
später noch beschrieben werden. In der Heizstation 4
erfolgt eine flächendeckende Beheizung der beiden Seiten des Schichtträgers 3, und nach Beendigung des Aufheizens wird der Schichtträger 3 in Richtung einer
Laminierstation 9 transportiert. Die Laminierstation 9
besteht aus zwei Laminierwalzen 10 und 11, von denen
beispielsweise die untere Laminierwalze 11 von einem
Motor 12 angetrieben wird. Selbstverständlich kann
auch die obere Laminierwalze anstelle der unteren Laminierwalze von einem Motor angetrieben werden. Die
andere Laminierwalze wird dann stets über Zahnräder,
Kettenräder mit Kette oder dgl. synchron mitangetrieben.

Oberhalb der Laminierstation 9 befindet sich ein vertikal ausgerichteter Vakuumtisch 17 und unterhalb der
Laminierstation 9 ist ein weiterer vertikal ausgerichteter Vakuumtisch 18 vorhanden. Die Vakuumtische
17 und 18 sind explosionsartig auseinandergezogen dar-

E  L  T  I  Apparatebau und Elektronik GmbH
und
H O E C H S T   A K T I E N G E S E L L S C H A F T
KALLE  Niederlassung der Hoechst AG

- 8 -

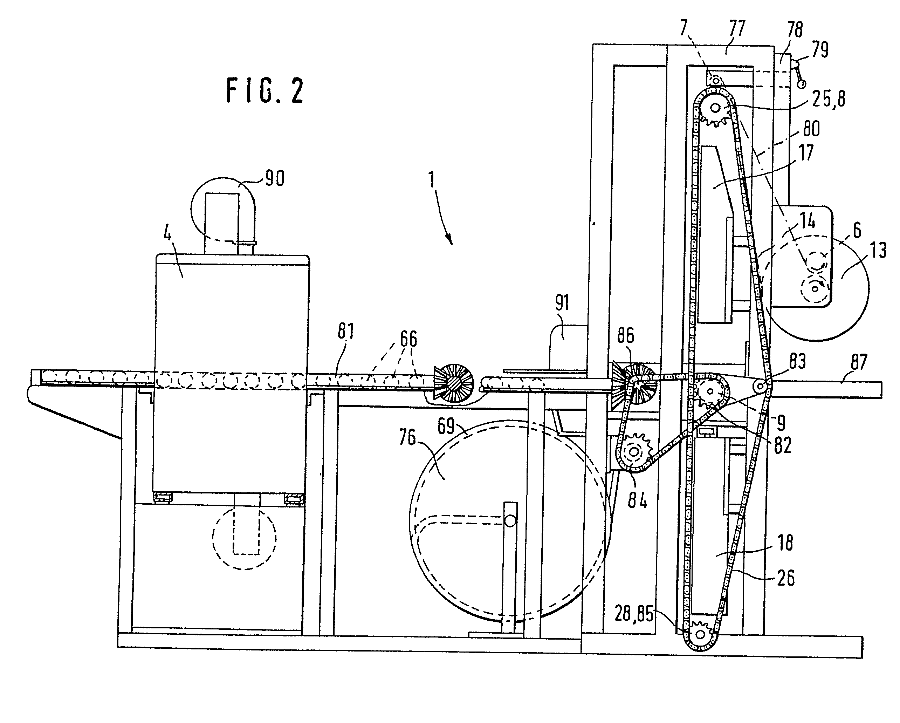

gestellt. Bei einer praktischen Ausführungsform der Laminiervorrichtung 1, wie sie beispielsweise in den Fig. 2 bis 4 gezeigt ist, befinden sich die Vakuumtische 17 und 18 näher an der Laminierstation und ihre sich gegenüber liegenden Kanten haben voneinander einen Abstand, der nur geringfügig größer als der Walzenspalt der beiden Laminierwalzen 10 und 11 ist.

Eine einzige Vorratsrolle 13 für den Fotoresistfilm 14 ist seitlich hinter dem oberen Vakuumtisch 17 angeordnet. Der Fotoresistfilm 14 wird schräg nach oben von der Vorratsrolle 13 um eine Umlenk- und Filmtransportrolle 8 herumgeführt und vertikal auf die Saugplatte des Vakuumtisches 17 und von diesem über die Laminierstation 9 nach unten auf die Saugplatte des Vakuumtisches 18 umgelenkt. In diesem Zusammenhang wird darauf hingewiesen, daß Fig. 1 nur ein Schema der Laminiervorrichtung 1 wiedergibt, wobei einzelne Bauteile und Stationen der Laminiervorrichtung aus Gründen der besseren Übersichtlichkeit weggelassen sind, da sie im übrigen in den folgenden Figuren ohnehin dargestellt und anhand dieser Figuren beschrieben werden. Nahe der oberen Kante des oberen Vakuumtisches 17 ist schematisch eine Schneideinrichtung 15 in Gestalt eines Rotationsmessers dargestellt, das höhenverstellbar ist und in Richtung des Doppelpfeils D über den Vakuumtisch 17 verfahren werden kann. Durch die Bezugszahl 15' ist eine Position der Schneideinrichtung im Bereich des unteren Vakuumtisches 18 angedeutet. In dieser Lage ist die Schneideinrichtung gleichfalls quer

ELTI Apparatebau und Elektronik GmbH
und
HOECHST AKTIENGESELLSCHAFT
KALLE Niederlassung der Hoechst AG

- 9 -

über den Vakuumtisch 18 in Richtung des Doppelpfeils D' verfahrbar. Die beiden Vakuumtische 17,18 sind ortsfest angeordnet und ihre oberen Deckflächen bilden Saugplatten mit kleinen Löchern. Die Schneideinrichtung 15 ist entlang Führungsstangen 29 und 30 verfahrbar, die vertikal zu beiden Seiten der Vakuumtische 17 und 18 verlaufen. Zwei Führungen 31 und 32, welche entlang den Führungsstangen 29 und 30 gleiten, sind mit einem Querträger 33 verbunden, an dem ein später noch zu beschreibender schwenkbarer Messerträger mit Zahnstange für die Schneideinrichtung 15 mit zwei Armen befestigt ist. Eine Greiferleiste 20 ist mit Führungen 21 und 22 verbunden, die in Richtung des Doppelpfeils E entlang den Führungsstangen 29 und 30 verschiebbar sind. Die Greiferleiste erfaßt in ihrer oberen Stellung den um die Umlenk- und Filmtransportrolle 8 herumgeführten Fotoresistfilm 14 und wird anschließend über den Vakuumtisch 17, die Laminierstation 9 in Richtung Unterkante des unteren Vakuumtisches 18, in eine Position entsprechend der Größe der zu laminierenden Plattenfläche, verfahren. Während dieser Bewegung besteht Vakuum innerhalb der Vakuumtische 17 und 18, so daß der Fotoresistfilm 14 faltenfrei über die Saugplatten der Vakuumtische 17 und 18 hinweggeführt werden kann. Sobald die Greiferleiste 20 ihre Endposition erreicht hat, bleiben die Vakuumtische 17 und 18 mit Saugluft beaufschlagt und dadurch der Fotoresistfilm 14 faltenfrei auf den Saugplatten der Vakuumtische aufgespannt. Der Fotoresistfilm 14 überspannt dabei auch den Spalt zwischen den Laminier-

E  L  T  I  Apparatebau und Elektronik GmbH
und
H O E C H S T   A K T I E N G E S E L L S C H A F T
KALLE  Niederlassung der Hoechst AG

0163315

- 10 -

walzen 10 und 11. Der in der Heizstation 4 beidseitig aufgeheizte Schichtträger 3 wird aus der Heizstation 4 horizontal auf den Spalt zwischen den beiden Laminierwalzen 10 und 11 hintransportiert, nachdem er zuvor an einem nicht gezeigten Plattenanschlag ausgerichtet wurde. Sobald der aufgeheizte Schichtträger den vertikal aufgespannten Fotoresistfilm 14 berührt, wird der Schichtträger 3, der durch die rotierenden Laminierwalzen 10 und 11 erfaßt wird, zusammen mit dem freigegebenen Fotoresistfilm 14 in den Spalt hineingezogen. Den Verbund aus Schichtträger 3 und dem sich gleichzeitig auf seine Ober- und Unterseite anlegenden Fotoresistfilm 14 transportieren die Laminierwalzen 10 und 11 in Richtung des Pfeils C durch die Laminierstation 9 hindurch. Beim Durchgang des Schichtträgers 3 durch die Laminierstation 9 wird der Fotoresistfilm 14 unter Druckkontakt auf die beiden Seiten des Schichtträgers 3 laminiert und aus der Laminierstation tritt der laminierte Schichtträger 3' aus. Dieser wird horizontal zur Weiterverarbeitung oder zur Ablage in einem Ablagebehälter 23 weitertransportiert.

In der schematischen Zeichnung nach Fig. 1 sind nicht alle Verfahrensstationen der Laminiervorrichtung dargestellt, die beispielsweise in den Fig. 2 bis 9b wiedergegeben sind.

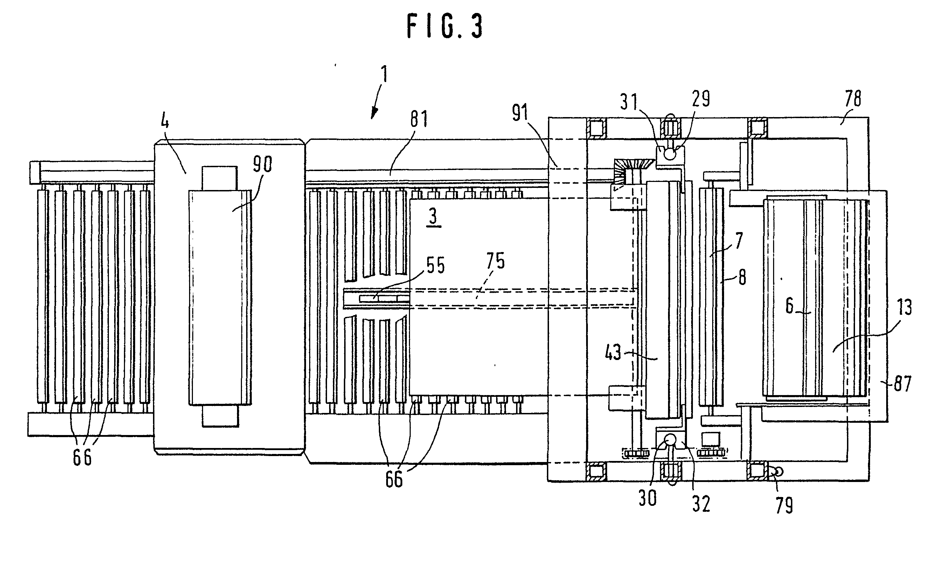

In den Fig. 2 bis 9b sind übereinstimmende Bauteile mit den gleichen Bezugszahlen belegt. Fig. 2 zeigt eine Schnittansicht und Fig. 3 die dazugehörige Draufsicht

E L T I  Apparatebau und Elektronik GmbH
und
H O E C H S T   A K T I E N G E S E L L S C H A F T
KALLE  Niederlassung der Hoechst AG

- 11 -

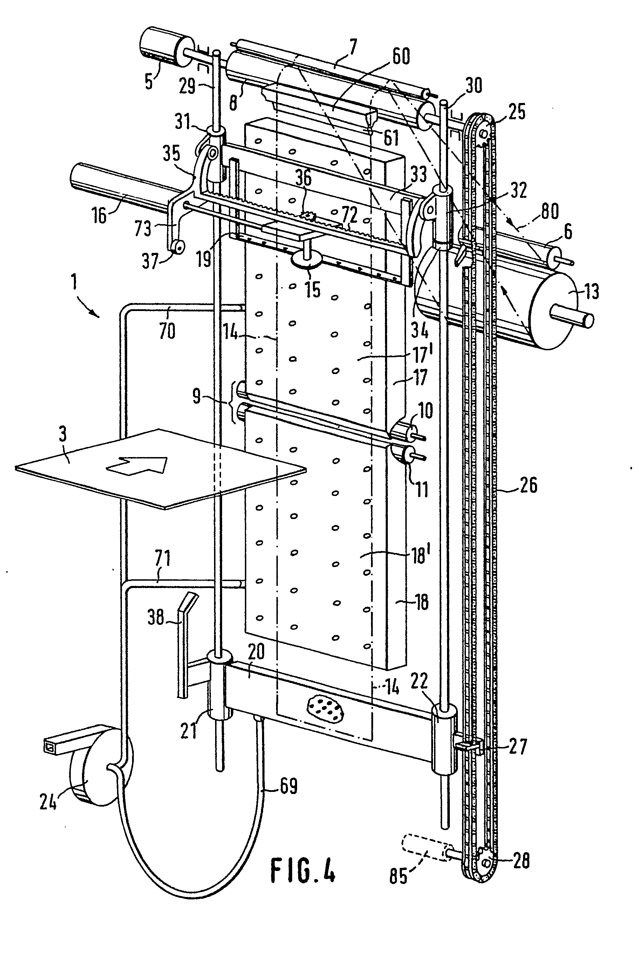

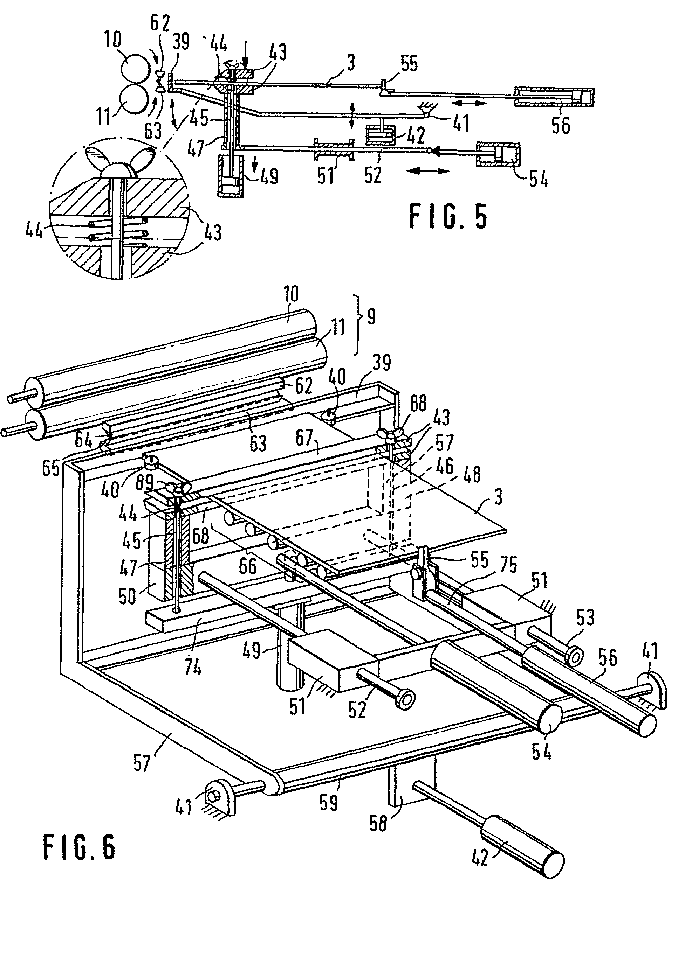

der Laminiervorrichtung 1. Ein von links nach rechts transportierter Schichtträger 3 wird entlang einer Rollenbahn 66 mit einer oder mehreren angetriebenen Rollen durch die Heizstation 4 hindurchtransportiert. Die Heizstation 4 umschließt zur Gänze die Rollenbahn 66 und hat sowohl in ihrem oberhalb der Rollenbahn 66 liegenden Teil als auch in ihrem unterhalb der Rollenbahn 66 befindlichen Teil je einen Wärmestrahler zur gleichmäßigen Flächenaufheizung der Ober- und der Unterseite des Schichtträgers 3. Gebläse der Heizstation 4 sorgen für eine entsprechende Luftumwälzung im Inneren der Heizstation zur Vergleichmäßigung der Aufheizung des Schichtträgers. Der aufgeheizte Schichtträger 3 tritt aus der Heizstation 4 aus und wird auf der Rollenbahn 66 zuerst in nichtgezeigter Weise seitlich ausgerichtet und anschließend in Richtung eines Parallelanschlags 39 transportiert, der später noch anhand der Fig. 5 und 6 näher beschrieben werden wird. Der Plattenanschlag 39 dient zum Ausrichten der Vorderkante des Schichtträgers 3, bevor dieser in die Laminierstation 9 transportiert wird. Zwischen der Heizstation 4 und der Laminierstation 9 befindet sich unterhalb der Rollenbahn 66 eine Aufwickelrolle 76 für eine Vakuumleitung 69 (Fig. 4), die mit der Greiferleiste 20 in Form einer Vakuumleiste verbunden ist. Ein Motor 84 bildet den Hauptantrieb für die Laminiervorrichtung 1 und treibt beispielsweise eine Zahnradkette an, die über ein Doppelkettenrad 82 und ein Kegelzahnrad 86 sowie ein auf der Antriebswelle des Motors 84 aufsitzendes Zahnrad endlos geführt ist. Das

0163315

E  L  T  I  Apparatebau und Elektronik GmbH
                       und
H O E C H S T   A K T I E N G E S E L L S C H A F T
KALLE  Niederlassung der Hoechst AG

- 12 -

Kegelzahnrad 86 ist im Eingriff mit einer Welle 81, die eine oder mehrere Rollen der Rollenbahn 66 antreibt. Über das Doppelkettenrad 82 und eine Rolle 83 im Auslauf der Laminierstation 9, und zwar am Beginn einer Auslaufbahn 87, ist eine endlose Kette geführt, die die Rolle 83 antreibt, um den aus der Laminierstation 9 austretenden laminierten Schichtträger 3' weiterzutransportieren. In einem Hauptrahmen 77 sind der obere Vakuumtisch 17 und der untere Vakuumtisch 18 angeordnet, sowie die Laminierstation 9, von der in Fig. 2 nur die untere Laminierwalze angedeutet ist, die in der Ansicht von dem Doppelkettenrad 82 verdeckt ist. Die obere Laminierwalze ist in Fig. 2 nicht dargestellt. Im Hauptrahmen 77 ist eine Antriebskette 26, die noch anhand von Fig. 4 näher beschrieben wird, um ein oberes Kettenrad 25 und ein unteres Kettenrad 28 endlos herumgeführt. Ein Schwenkrahmen 78 ist seitlich an den Hauptrahmen 77 angelenkt und wird mittels einer Verriegelung 79 mit dem Hauptrahmen 77 fest verbunden. In Fig. 2 ist die Verriegelung 79 oben am Schwenkrahmen 78 angeordnet, jedoch kann sie ebenso im unteren Bereich des Schwenkrahmens 78 vorgesehen werden. In dem Schwenkrahmen 78 sind die Vorratsrolle 13 für den Fotoresistfilm 14 und eine Aufnahmerolle 6 für eine Schutzfolie 80, die den Fotoresistfilm 14 abdeckt, gelagert. Die Schutzfolie 80 wird im Bereich der Umlenk- und Filmtransportrolle 8, die in der Ansicht in Fig. 2 von dem Kettenrad 25 verdeckt ist, von dem Fotoresistfilm 14 mit Hilfe einer Andruck- und Trennrolle 7 abgetrennt und um diese Andruck- und Trennrolle 7 herumgeführt und auf die Aufnahmerolle 6 aufgewickelt.

E L T I  Apparatebau und Elektronik GmbH
und
H O E C H S T  A K T I E N G E S E L L S C H A F T
KALLE  Niederlassung der Hoechst AG

- 13 -

In der Draufsicht nach Fig. 3 ist das obere Gebläse 90 der Heizstation 4 zur Vereinfachung der Zeichnung nur schematisch dargestellt. Nach der Heizstation 4 verläuft entlang der Mittellinie der Rollenbahn 66 eine Führung 75, in der ein umklappbarer Transportfinger 55 verschiebbar ist. Dieser Transportfinger 55 liegt im aufgerichteten Zustand an der Hinterkante des Schichtträgers 3 an und transportiert diesen in Richtung der Laminierstation 9. In der Draufsicht sind eine Ausrichteinrichtung 91 zum seitlichen Ausrichten des Schichtträgers und der Parallelanschlag 39 zum Ausrichten der Vorderkante des Schichtträgers 3 zu erkennen, sowie ein Plattengreifer 43, der bis nahe an die Laminierstation herangefahren ist. Führungen 31 und 32 sind entlang Führungsstangen 29 und 30 verfahrbar und durch einen Querträger 33 (Fig. 4) miteinander verbunden.

Fig. 4 zeigt in perspektivischer Ansicht das Kernstück der Laminiervorrichtung 1. Gegenüber der Laminiervorrichtung nach den Fig. 2 und 3 umfaßt diese Laminiervorrichtung noch zusätzlich eine Auftragseinrichtung 60 zum Aufbringen einer Flüssigkeitsschicht auf die Vorderseite des über die Vakuumtische 17 und 18 nach unten transportierten Fotoresistfilms 14. Die Auftragseinrichtung 60 enthält ein Wischerblatt 61, das aus der Auftragseinrichtung herausragt und gegen die Oberfläche bzw. Seite des Fotoresistfilms 14 anliegt, die sich an die beiden Seiten des Schichtträgers 3 während des Laminierens anlegt und auf der Ober- und

E L T I Apparatebau und Elektronik GmbH
und
H O E C H S T   A K T I E N G E S E L L S C H A F T
KALLE  Niederlassung der Hoechst AG

0163315

- 14 -

Unterseite des Schichtträgers 3 nach dem Laminieren haftet. Durch das Wischerblatt 61 wird eine Flüssigkeitsschicht in der Größenordnung von bis zu 100 Mikromillimeter auf dem Fotoresistfilm aufgetragen. Die Flüssigkeitsschicht besteht beispielsweise aus einer Mischung aus destilliertem Wasser und Methanol, Ethanol oder Fluorkohlenstofflösungen von Alkoholen. Die Flüssigkeitsschicht kann auch eine Haftmittelschicht sein, die eine geringe Menge aufgelösten Fotoresistmaterials enthält, das ein Füllmaterial für sehr kleine Oberflächenunebenheiten des Schichtträgers 3 bildet. Die Flüssigkeitsschicht hat vor allem den Zweck, beim Auflaminieren des Fotoresistfilms 14 auf die Ober- und Unterseite des Schichtträgers 3 die Bildung von Lufteinschlüssen zu verhindern und dadurch die Haftung zu beschleunigen und zu verbessern.

Das Wischerblatt 61 besteht zweckmäßigerweise aus einem Material mit einer bestimmten Kapillarität, wie beispielsweise aus einem filz- oder einem dochtartigen Material. Es sind auch andere Auftragseinrichtungen, wie Sprühvorrichtungen, Rakelvorrichtungen mit Stauwirkung Beschichtungswalzen oder dgl. einsetzbar.

Bei der Laminiervorrichtung 1 nach Fig. 4 ist der schon aufgeheizte und ausgerichtete Schichtträger 3 kurz vor dem Einlauf in den Spalt zwischen den beiden Laminierwalzen 10 und 11 dargestellt. Oberhalb und unterhalb der Laminierstation 9 sind die Vakuumtische 17 und 18 mit ihren vertikalen Saugplatten 17' und 18'

E L T I  Apparatebau und Elektronik GmbH
und
H O E C H S T   A K T I E N G E S E L L S C H A F T
KALLE  Niederlassung der Hoechst AG

- 15 -

angeordnet. Die Ausgestaltung der Vakuumtische 17 und 18 wird noch näher beschrieben werden. Die Laminierstation 9 ist Gegenstand der deutschen Patentanmeldung P 34 20 409.1, die zusammen mit der vorliegenden Anmeldung am gleichen Tag eingereicht wurde.

Unterhalb des unteren Vakuumtisches 18 befindet sich die Greiferleiste 20, die als Vakuumleiste ausgebildet ist und über die flexible Vakuumleitung 69 mit einer schematisch angedeuteten Vakuumpumpe 24 verbunden ist. Diese flexible Vakuumleitung 69 ist, wie schon im Zusammenhang mit Fig. 2 erwähnt wurde, während der vertikalen Hin- und Herbewegung der Greiferleiste 20 auf die Aufwickelrolle 76, gezeigt in Fig. 2, aufwickelbar oder von dieser Rolle abwickelbar. Die Greiferleiste 20 ist mit zwei Führungen 21 und 22 verbunden, die entlang der Führungsstangen 29 und 30 mit Hilfe der Antriebskette 26 verschiebbar sind. Auf der einen Führung 22 der Greiferleiste 20 ist ein Kettenanschluß 27 angebracht, der mit der Antriebskette 26 kraftschlüssig verbunden ist. Die Antriebskette 26 ist endlos um die Kettenräder 25 und 28 herumgeführt und wird beispielsweise von einem Motor 85 in Bewegung gesetzt, der mit dem unteren Kettenrad 28 in Verbindung steht. Der Motor 85 ist in Fig. 4 gestrichelt gezeichnet, um anzudeuten, daß er nur eine Alternative für den Antrieb der Antriebskette 26 darstellt, die bevorzugt über das obere Kettenrad 25 angetrieben wird, das auf der Welle der Umlenk- und Filmtransportrolle 8 auf-

E L T I  Apparatebau und Elektronik GmbH
                        und
H O E C H S T   A K T I E N G E S E L L S C H A F T
KALLE  Niederlassung der Hoechst AG

- 16 -

sitzt, die ihrerseits von dem Antriebsmotor 5 in Drehung versetzt wird. Es ist selbstverständlich, daß entweder nur der Antriebsmotor 5 oder nur der Motor 85 vorhanden sind, nicht jedoch beide Motoren zugleich.

Der Antriebsmotor 5 treibt die Umlenk- und Filmtransportrolle 8 nur in einer Richtung an. Die andere Richtung hierzu wird mittels einer Rücklaufsperre blokkiert, um zu verhindern, daß der Fotoresistfilm 14 beim Hochlaufen der Greiferleiste 20 rückwärts transportiert wird.

Die einzige Vorratsrolle 13 für den Fotoresistfilm 14 der Laminiervorrichtung 1 liegt in Transportrichtung des Schichtträgers 3 hinter dem oberen Vakuumtisch 17, und ist in dem in Fig. 4 aus Gründen der besseren Übersichtlichkeit weggelassenen Schwenkrahmen 78, gezeigt in den Fig. 2 und 3, gelagert, der um eine Vertikalachse horizontal verschwenkbar ist. Dadurch ist bei Bedarf ein Auswechseln der Vorratsrolle 13 durch Wegschwenken des Schwenkrahmens von dem Hauptrahmen ohne Schwierigkeiten möglich. Von der Vorratsrolle 13 wird der Fotoresistfilm 14 über die Umlenk- und Filmtransportrolle 8 herumgeführt und ein streifenförmiger Abschnitt des Fotoresistfilms 14 von der Greiferleiste 20, die dann hochgefahren ist, erfaßt und über die Saugplatten 17 ' und 18' der Vakuumtische 17 und 18 nach unten transportiert. Auf dem Fotoresistfilm 14 haftet die Schutzfolie 80, die beim Umlenken des Fotoresistfilms 14 um die Umlenk- und Film-

E L T I Apparatebau und Elektronik GmbH
und
H O E C H S T   A K T I E N G E S E L L S C H A F T
KALLE   Niederlassung der Hoechst AG

- 17 -

transportrolle 8 abgezogen und über die Andruck- und
Trennrolle 7 auf die Aufnahmerolle 6, die nahe der
Vorratsrolle 13 angeordnet ist, geführt wird. Im geringen Abstand unterhalb der Umlenk- und Filmtransportrolle 8 befindet sich die Auftragseinrichtung 60,
deren Wischerblatt 61 an dem Fotoresistfilm 14 anliegt.

Die Vakuumtische 17 und 18 sind über Vakuumleitungen
70 und 71 mit der Vakuumpumpe 24 verbunden. Ein Messerträger 35 weist eine Zahnstange 72 auf und ist
schwenkbar an den Führungen 31 und 32 gelagert, die
entlang den Führungsstangen 29 und 30 verschiebbar
sind. Die Führungen 31 und 32 verbindet der Querträger
33, an dem mit entsprechenden, nicht näher bezeichneten Streben eine quer zu dem Fotoresistfilm 14 verlaufende Schiene 19 mit Schneidkanten befestigt ist. An
der einen Führung 32 ist ein Klemmstück 34 mit einem
Griff angebracht, das es ermöglicht, den Querträger 33
und die mit ihm verbundenen Teile in der gewünschten
Höhe auf den Führungsstangen 29 und 30 festzulegen
bzw. festzuklemmen. Anstelle des mechanisch arbeitenden Klemmstücks wird bevorzugt eine elektromotorisch
betätigte Positioniervorrichtung vorgesehen, die den
Querträger entlang den Führungsstangen 29,30 verfährt
und festlegt. Mit der Zahnstange 72 steht ein Getriebe
36 für den Messerantrieb im Eingriff, das von einem
Motor 16 angetrieben und über die Breite des Fotoresistfilms 14 verfahren wird. Das Getriebe 36 treibt
die mit ihm verbundene Schneideinrichtung 15, bei-

E L T I Apparatebau und Elektronik GmbH
und
H O E C H S T   A K T I E N G E S E L L S C H A F T
KALLE  Niederlassung der Hoechst AG

- 18 -

spielsweise ein Rotationsmesser, an und versetzt die
Schneideinrichtung in Drehung und bewegt sie entlang
der Schneidkante der Schiene 19 über den Fotoresistfilm 14 während des Schneidens. An dem Messerträger 35
ist ein Winkelarm 73 angeordnet, der an seinem freien
Ende eine nach innen zeigende, d.h. der Kante des
Fotoresistfilms 14 zugewandte Kurvenrolle 37 trägt. An
der einen Führung 21 der Greiferleiste 20 ist ein abgewinkeltes Kurvenstück 38 befestigt, das beim Hochfahren der Greiferleiste 20 mit der Kurvenrolle 37 in
Berührung gelangt, die auf dem Kurvenstück 38 abrollt
und dabei den Winkelarm 73 und den Messerträger 35 zusammen mit der Schneideinrichtung 15 von dem Fotoresistfilm 14 abhebt. Dadurch ist es möglich, daß die
Greiferleiste 20 unter dem von der Oberfläche des
Fotoresistfilms 14 abgehobenen Messerträger 35 und der
abgehobenen Schneideinrichtung 15 hindurch so weit
nach oben verfahren wird, daß ein Streifen des Fotoresistfilms 14 unterhalb des Querträgers 33 durch Anlegen  von Vakuum an die Greiferleiste 20 angesaugt und
festgehalten werden kann.

Durch den Antrieb mittels des Motors 5 der Umlenk- und
Filmtransportrolle 8 wird das Abziehen des Fotoresistfilms 14 von der Vorratsrolle 13 durch die sich nach
unten bewegende Greiferleiste 20 in großem Umfang unterstützt und erleichtert. Dabei ist von Vorteil, daß
die Drehbewegung der Umlenk- und Filmtransportrolle 8
sowie die Abwärtsbewegung der Greiferleiste 20 über
den gemeinsamen Antrieb durch die Antriebskette 26
miteinander synchronisiert sind.

E L T I Apparatebau und Elektronik GmbH
und
H O E C H S T   A K T I E N G E S E L L S C H A F T
KALLE Niederlassung der Hoechst AG

- 19 -

In Fig. 5 ist schematisch und in Fig. 6 perspektivisch von einer weiteren Laminiervorrichtung 1 ein Teil dargestellt, der vor der Laminierstation 9 liegt und den Parallelanschlag 39, die Rollenbahn 66 und den Plattengreifer 43 mit den jeweiligen Betätigungsmechanismen umfaßt. Bei dieser Laminiervorrichtung 1 sind, im Unterschied zu derjenigen nach den Fig. 2 bis 4, zwischen der Laminierstation und dem in die Rollenbahn 66 eingeschwenkten Parallelanschlag 39 Auftragseinrichtungen 62 und 63 zum Aufbringen einer Flüssigkeitsschicht auf der Ober- und Unterseite des horizontal transportierten Schichtträgers 3 angeordnet. Es ist selbstverständlich, daß bei dieser Ausführungsform der Laminiervorrichtung die in Fig. 4 enthaltene Auftragseinrichtung 60 zum Aufbringen einer Flüssigkeitsschicht auf der Vorderseite des über die Vakuumtische 17 und 18 nach unten transportieren Fotoresistfilms 14 nahe der Umlenkrolle 8 für den Fotoresistfilm weggelassen wird. Andererseits gilt, daß bei der Laminiervorrichtung 1 nach Fig. 4 die in Fig. 6 gezeigten beiden Auftragseinrichtungen 62 und 63 nicht erforderlich sind. Die beiden Laminiervorrichtungen unterscheiden sich einzig und allein dadurch, daß in der Laminiervorrichtung nach den Fig. 2 bis 4 eine Flüssigkeitsschicht direkt auf den Fotoresistfilm 14 aufgetragen wird, während bei der Laminiervorrichtung 1 nach den Fig. 5 und 6 auf die Ober- und Unterseite des Schichtträgers 3 die Flüssigkeitsschicht aufgetragen wird. In der Praxis wird selbstverständlich auch eine Laminiervorrichtung 1 verwendet werden, die ohne Auftrag einer

E  L  T  I  Apparatebau und Elektronik GmbH
und
H O E C H S T  A K T I E N G E S E L L S C H A F T
KALLE  Niederlassung der Hoechst AG

0163315

- 20 -

Flüssigkeitsschicht auf den Fotoresistfilm bzw. auf die Ober- und Unterseite des Schichtträgers 3 arbeitet und bei der der Fotoresistfilm nur unter Anwendung von Wärme und Druck auflaminiert wird.

Die Auftragseinrichtungen 62 und 63 sind entsprechend der zuvor beschriebenen Auftragseinrichtung 60 ausgebildet und das jeweilige Wischerblatt 64 bzw. 65 liegt auf der Oberseite bzw. Unterseite des Schichtträgers 3 an. Die aufzutragende Flüssigkeitsschicht entspricht weitgehend der zuvor im Zusammenhang mit der Auftragseinrichtung 60 beschriebenen Flüssigkeitsschicht.

Der Parallelanschlag 39 ist an zwei Winkelhebeln 57,57 befestigt, die über einen zylindrischen Verbindungsträger 59 an dem einen Ende miteinander verbunden sind, während das andere Ende der Winkelhebel den Parallelanschlag 39 trägt. Dieser Parallelanschlag 39 ist beispielsweise winkelförmig ausgebildet und an ihm sind zwei horizontal verschwenkbare Führungsröllchen 40,40 angeordnet, die sich an die Längskanten des Schichtträgers 3 anlegen, wenn dessen Vorderkante an dem Parallelanschlag 39 anliegt und ausgerichtet wird. Die über die Winkelhebel 57,57 hinaus verlängerte Achse des Verbindungsträgers 59 ist in Lagern 41,41 drehbar gelagert. An dem Verbindungsträger 59 befindet sich eine Platte 58, an der ein Betätigungszylinder 42 für die Winkelhebel 57,57 angreift, um diese, und damit den Parallelanschlag 39, in die und aus der Bahn des Schichtträgers 3 zu schwenken.

- 21 -

Der horizontal verfahrbare Plattengreifer 43 umfaßt zwei horizontale, übereinander liegende Klemmbacken 67 und 68, zwischen denen Federn 44,44, welche Zugstangen 45 und 46 umgeben, zum Öffnen des Plattengreifers 43 angeordnet sind. Die Zugstangen laufen in Führungen 47 und 48 und durchsetzen die Klemmbacken 67 und 68. Des weiteren sind die Zugstangen 45 und 46 mit der Querstrebe 74 des Plattengreifers 43 verbunden und tragen am oberen Ende jeweils ein Gewinde, das mit einer dazu gehörigen Flügelmutter 88 bzw. 89, oberhalb der oberen Klemmbacke 67, verschraubt ist. Wird der Kolben des Zylinders 49 eingefahren, so wird die Querstrebe 74 nach unten gezogen und gleichzeitig die über die Zugstangen 45 und 46 mit der Querstrebe 74 verbundene obere Klemmbacke 67 gegen die Federkraft der Federn 44,44 nach unten bis zum Anliegen an der Oberseite des Schichtträgers 3 und zum Ergreifen des Schichtträgers bewegt. An dem Träger 50 des Plattengreifers 43, der sich unterhalb der Klemmbacken 67,68 befindet, sind zwei zueinander parallele, horizontale, durch Führungslager 51,51 verlaufende Führungsstangen 52,53 befestigt. Ein Betätigungszylinder 54 greift an dem Träger 50 an und verfährt den Plattengreifer 43 waagerecht hin und her.

In Transportrichtung des Schichtträgers 3 gesehen ist vor der Rollenbahn 66 der umklappbare Transportfinger 55 angeordnet, den ein Zylinder 56 hin- und herverschiebt und der sich aus der umgeklappten Ausgangsstellung auf Grund seines Eigengewichts aufrichtet.

E L T I Apparatebau und Elektronik GmbH
und
H O E C H S T  A K T I E N G E S E L L S C H A F T
KALLE  Niederlassung der Hoechst AG

- 22 -

Dies geschieht, sobald die Hinterkante des Schichtträgers 3 den Transportfinger 55 passiert hat. Der aufgeklappte Transportfinger 55 liegt an der Hinterkante des Schichtträgers 3 an und schiebt diesen solange vorwärts, bis seine Vorderkante an den, in die Bahn des Schichtträgers 3 hineingeschwenkten Parallelanschlag 39 anliegt und durch den Parallelanschlag ausgerichtet wird. Sobald dies geschehen ist, wird der Transportfinger 55 durch den Zylinder 56 in seine Ausgangsstellung zurückbewegt und durch den darüberlaufenden Schichtträger umgeklappt. Zugleich wird der Parallelanschlag 39 aus der Bahn des Schichtträgers 3 herausgeschwenkt, der Plattengreifer 43 geschlossen und der festgehaltene Schichtträger 3 von dem Plattengreifer 43 in Richtung der Laminierstation 9 weitertransportiert. Sobald die Laminierwalzen 10 und 11 die Vorderkante des Schichtträgers 3 erfassen, öffnet der Plattengreifer 43, um den Schichtträger 3 freizugeben, und wird in seine Ausgangsstellung zurückgefahren.

An Stelle der Greiferleiste 20 in Gestalt einer Vakuumleiste kann auch eine mechanische Greifereinrichtung vorgesehen werden, die aus zahnartig profilierten Leisten besteht, von denen z.B. die obere Leiste federbelastet ist. Das Öffnen und Schließen der Greifereinrichtung erfolgt mit Hilfe eines Exzenters, der einen Nocken trägt. Ein Hebel des Exzenters liegt in der Schließstellung an einem Anschlag an, wodurch der Exzenter parallel gestellt wird und die federbelastete obere Leiste nach unten drückt. In der Öffnungsstel-

E L T I Apparatebau und Elektronik GmbH
und
H O E C H S T   A K T I E N G E S E L L S C H A F T
KALLE  Niederlassung der Hoechst AG

- 23 -

lung liegt der Hebel an einem anderen Anschlag an,
wird hochkant gestellt und drückt die beiden Leisten
gegen den Federdruck auf die obere Leiste auseinander,
um den Fotoresistfilm freizugeben. Die Greifereinrichtung wird über den Kettenantrieb, eine Zahnstange oder
pneumatisch über die Vakuumtische vertikal verfahren.
Die mechanische Greifereinrichtung ist in der deutschen Patentanmeldung P 34 20 409.1 mit gleichem Anmeldetag wie die vorliegende Anmeldung näher beschrieben.

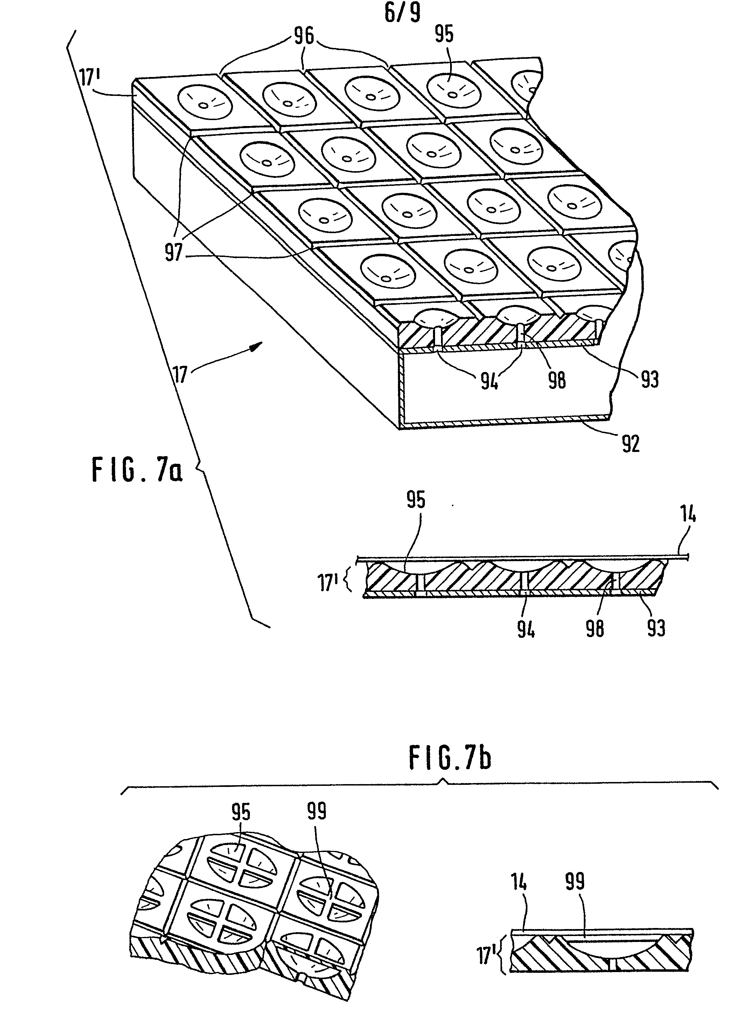

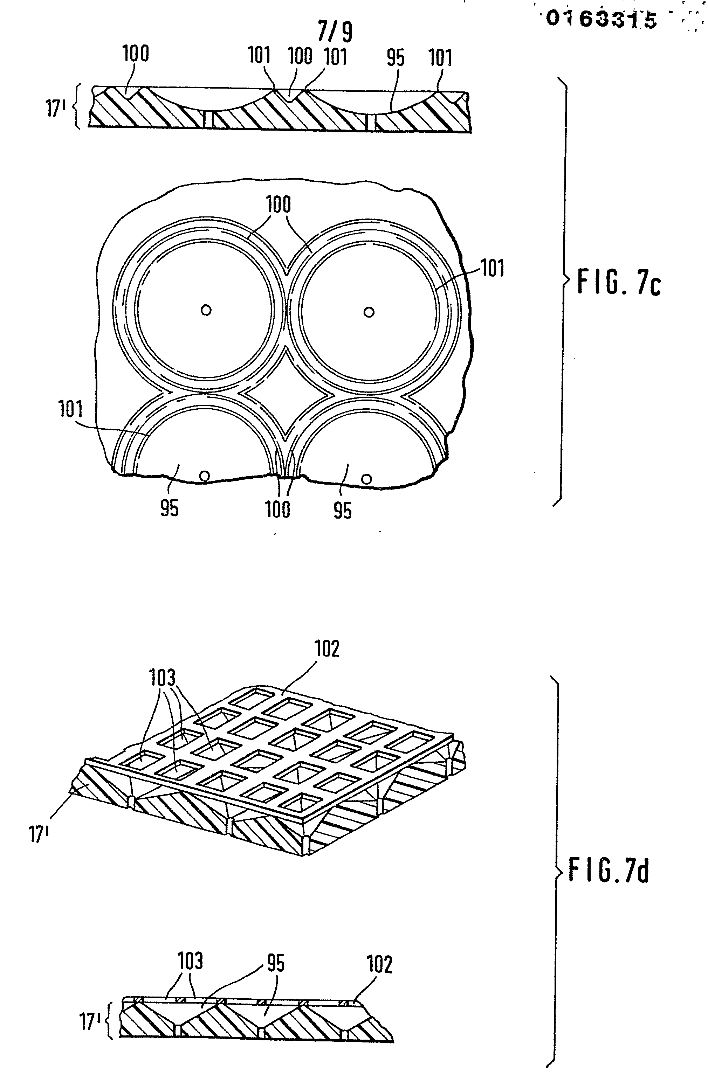

In den Figuren 7a, b, c, d sind verschiedene Ausgestaltungen der Saugplatte 17' des Vakuumtisches 17
dargestellt. Der Vakuumtisch 18 und seine Saugplatte
18' sind hierzu identisch ausgebildet. Der zugrundeliegende Gedanke ist dabei stets, auf den angesaugten
Fotoresistfilm eine Saugkraft nur in einer Stärke auszuüben, die ein müheloses Ziehen des Fotoresistfilms
über die Saugfläche ohne die Gefahr seiner Beschädigung zuläßt.

Ein Gehäuse 92 des Vakuumtisches 17 ist, wie im Zusammenhang mit Fig. 4 beschrieben wurde, mit der Vakuumpumpe 24 verbunden. Auf das Gehäuse 92 ist ein Blechgehäuse 93 mit Anschlußöffnungen 94 aufgesetzt, die
die Verbindung zwischen dem Inneren des Gehäuses 92
und zeilen- und reihenweise angeordneten Formbohrungen
95 in der Saugplatte 17 über Bohrungen 98 herstellen.
Die Saugplatte 17' ist beispielsweise eine Kunststoffplatte aus Hostaform(R) von 5 mm Stärke, die mit zwei

E L T I  Apparatebau und Elektronik GmbH
und
H O E C H S T   A K T I E N G E S E L L S C H A F T
KALLE  Niederlassung der Hoechst AG

- 24 -

Gitterscharen von gefrästen, scharweise zueinander parallelen Nuten 96,97 versehen ist, deren Tiefe bis zu 3 mm beträgt. Die Abstände der Mittellinien zweier benachbarter, zueinander paralleler Nuten 96,96 bzw. 97,97 liegen zwischen 15 bis 25 mm. Der Querschnitt der Nuten ist dreiecksförmig, kann jedoch auch rechteckige, halbkreisförmige oder sonstige Gestalt besitzen. Die Breite der einzelnen Nut in der Ebene der Saugplatte 17' entspricht in etwa der Nuttiefe. Die Formbohrungen 95 bilden kalottenförmige Vertiefungen in der Saugplatte 17', wobei der Durchmesser der Formbohrungen in der Ebene der Saugplattenoberfläche zwischen 10 bis 20 mm beträgt und zwischen dem Rand der einzelnen Formbohrung 95 und jeder der vier Nutenabschnitte, die die Formbohrung quadratisch umgeben, ein Steg von 1 bis 1,5 mm vorhanden ist. Vom tiefsten Punkt jeder Formbohrung 95 stellt eine Bohrung 98 in der Saugplatte 17' die Verbindung mit der zugehörigen Anschlußöffnung 94 im Blechgehäuse 93 her. Die Nuten 96 und 97 sind nicht an die Vakuumpumpe angeschlossen und dienen aussschließlich der Begrenzung der auf den Fotoresistfilm 14 ausgeübten Saugwirkung auf die Flächen der einzelnen Formbohrungen 95. Mit anderen Worten bedeutet dies, daß die Nuten die sich um eine Formbohrung 95 ausbildende geschlossene Vakuumfläche unterbrechen, so daß sich kein durchgehendes Vakuum von Formbohrung zu Formbohrung ausbilden kann und somit die gesamte im Bereich der Saugplatte 17' ausgeübte Saugkraft nicht zu groß wird, um ein Verschieben bzw. Ziehen des Fotoresistfilms 14 über den Vakuumtisch zu erschweren oder unmöglich zu machen.

E L T I   Apparatebau und Elektronik GmbH
und
H O E C H S T   A K T I E N G E S E L L S C H A F T
KALLE   Niederlassung der Hoechst AG

- 25 -

Fig. 7b zeigt eine andere Ausführungsform der Saugplatte des Vakuumtisches, die insbesondere für spröde
Fotoresistfilme mit geringer Festigkeit geeignet ist,
um Beschädigungen des Fotoresistfilms entlang den Rändern der Formbohrungen zu vermeiden, die dadurch entstehen könnten, daß das angelegte Vakuum den Fotoresistfilm mehr oder weniger stark in das Innere der
Formbohrungen zieht. Um das zu verhindern, ist in jeder Formbohrung 95 ein kreuzförmiger Steg 96 angeordnet, dessen Oberkanten mit der Oberfläche der Saugplatte 17' abschließen, so daß der Fotoresistfilm 14
im Bereich der Formbohrung 95 in der Ebene der Saugplattenoberfläche abgestützt ist und die Formbohrung
nicht frei überspannen muß. Die Abmessungen und die
sonstigen Ausgestaltungsmerkmale der Saugplatte 17'
stimmen mit denjenigen der Ausführungsform nach
Fig. 7a überein. Fig. 7c zeigt eine kostengünstig herzustellende Ausführungsform der Saugplatte 17', bei
der anstelle von geradlinigen Nuten kreisringförmige
Nuten 100 jede einzelne Formbohrung 95 umgeben und
Entlastungskanäle zur Beschränkung des angelegten Vakuums auf die Fläche der einzelnen Formbohrung bilden.
Diese Entlastungskanäle können mittels entsprechend
ausgebildeten Formfräsern in einem Arbeitsgang zusammen mit den Formbohrungen hergestellt werden. Zwischen
dem Rand der Formbohrung 95 und der sie umgebenden Nut
100 ist ein kreisförmiger Steg 101 von etwa 1 bis
1,5 mm Breite vorhanden. Benachbarte Nuten 100 der
reihen- und zeilenförmig angeordneten Formbohrungen
gehen überschneidend ineinander über. Die weitere Aus-

E L T I  Apparatebau und Elektronik GmbH
und
H O E C H S T  A K T I E N G E S E L L S C H A F T
KALLE  Niederlassung der Hoechst AG

- 26 -

gestaltung der Saugplatte stimmt mit derjenigen nach Fig. 7a überein.

Eine weitere, in Fig. 7d dargestellte Ausführungsform der Saugplatte 17' umfaßt neben der Saugplatte 17' mit den Formbohrungen 95 eine auf der Saugplatte obenauf befestigte Lochplatte 102 mit gleichgroßen rechteckförmigen oder quadratischen Durchbrüchen 103, die reihen- und zeilenweise angeordnet sind. Die Abmessungen der Durchbrüche 103 sind so gewählt, daß beispielsweise vier Durchbrüche über einer Formbohrung 95 zu liegen kommen. Die Stege zwischen den Durchbrüchen sorgen dafür, daß über der einzelnen Formbohrung voneinander getrennte Vakuumbereiche innerhalb der vier Durchbrüche entstehen und somit die auf den Fotoresistfilm ausgeübte Saugkraft eine bestimmte Stärke nicht überschreitet.

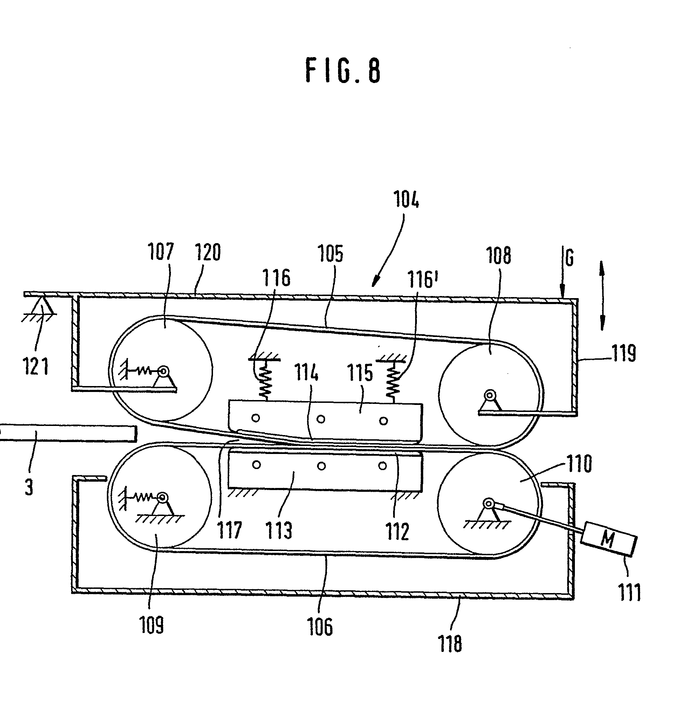

In Fig. 8 ist schematisch in Schnittansicht eine Heizvorrichtung 104 dargestellt, die an die Stelle der Heizstation 4 in Fig. 2 treten kann. Die Heizvorrichtung 104 weist zwei endlos umlaufende Transportbänder 105,106 auf, von denen jedes über je zwei Rollen 107,108 bzw. 109,110 geführt ist.

Das untere Transportband 106 ist über eine Transportrolle 109 und eine Antriebsrolle 110 geführt, die ein Motor 111 antreibt. Die Unterseite des Obertrums des Transportbandes 106 gleitet im Kontakt beim Umlauf des Transportbandes über eine plane Heizplatte 112 eines

E  L  T  I  Apparatebau und Elektronik GmbH
und
H O E C H S T   A K T I E N G E S E L L S C H A F T
KALLE  Niederlassung der Hoechst AG

- 27 -

lagefesten Elektroheizkörpers 113 und wird dabei aufgeheizt. Das oberè, nicht angetriebene Transportband 105 läuft über die Transportrollen 107,108 um und steht im leichten Druckkontakt mit dem angetriebenen unteren Transportband 106, so daß es von diesem durch Friktion mitgenommen wird und sich ein Synchronlauf der beiden Transportbänder einstellt. Das Untertrum des oberen Transportbandes 105 gleitet im Kontakt über eine Heizplatte 114 eines oberen Elektroheizkörpers 115, der das Transportband aufheizt. Die Heizplatte des Elektroheizkörpers 115 ist nach oben hin teilweise leicht abgeschrägt, ansonsten aber plan ausgebildet, so daß die sich gegenüberliegenden Elektroheizkörper 113,115 bzw. ihre Heizplatten einen sich verengenden Spalt 117 in Transportrichtung des Schichtträgers 3 bilden.

Der obere Elektroheizkörper 115 ist mittels Zugfedern 116,116' federnd aufgehängt, die sein Eigengewicht weitgehend kompensieren, so daß ein von den Transportbändern nach seinem Eintritt in den Spalt 117 erfaßter und weitertransportierter Schichtträger 3 den Elektroheizkörper 115 mit dem oberen Transportband 105 soweit nach oben drückt, daß sich ein Abstand bzw. ein Spalt zwischen den Transportbändern ausbildet, der den mühelosen Hindurchtransport des Schichtträgers 3 zuläßt. Von Vorteil ist dabei, daß die Transportbänder stets in Kontakt mit der Ober- und Unterseite des durchlaufenden Schichtträgers 3 sind und dieser daher gleichmäßig, ohne Unterbrechung, beidseitig aufgeheizt wird. Die in

E L T I Apparatebau und Elektronik GmbH
und
H O E C H S T  A K T I E N G E S E L L S C H A F T
KALLE Niederlassung der Hoechst AG

- 28 -

Transportrichtung sich zuerst gegenüberliegenden Transportrollen 107 und 109 weisen untereinander einen lichten Abstand auf, während die hintere Transportrolle 108 und die Antriebsrolle 110, nur getrennt voneinander durch die dazwischenliegenden Transportbänder, sich gegenüberliegen. Das Unterteil und das Oberteil der Heizvorrichtung 104 sind von einem Gehäuse 118 bzw. 119 umgeben. Das Unterteil ist mit seinem Gehäuse 118 ortsfest angebracht, während das Oberteil mit seinem Gehäuse 119 schwingend aufgehängt ist. Hierzu ist die Deckfläche 120 über die eine Seitenfläche des Gehäuses 119 verlängert und in einem Kipplager 121 gelagert.

Läuft kein Schichtträger 3 durch die Heizvorrichtung 104, so drückt das Eigengewicht das Gehäuse 119 nach unten, wie dies durch einen Pfeil G angedeutet ist. Wenn der Schichtträger 3 in der Heizvorrichtung 104 zwischen der hinteren Transportrolle 108 und der Antriebsrolle 110 hindurchläuft, wird die Transportrolle 108 zusammen mit dem Gehäuse 119 angehoben, da dieses infolge der Lagerung seiner Deckfläche 120 im Kipplager 121 nach oben um das Kipplager schwenkbar ist. Es kann sich dann der erforderliche Spalt für den Schichtträger 3 zwischen den hinteren Rollen selbsttätig einstellen.

An die Stelle der Heizstation 4 oder der Heizvorrichtung 104 kann auch eine Heizvorrichtung treten, in der Rohrheizkörper oberhalb und unterhalb der Bahn des Schichtträgers die von einem oder zwei Gebläsen gelie-

0163315

- 29 -

ferte Umluft erwärmen. Der Schichtträger wird dann durch die Heißluft erwärmt, die von den Gebläsen über Schlitzdüsen auf den Schichtträger geblasen wird.

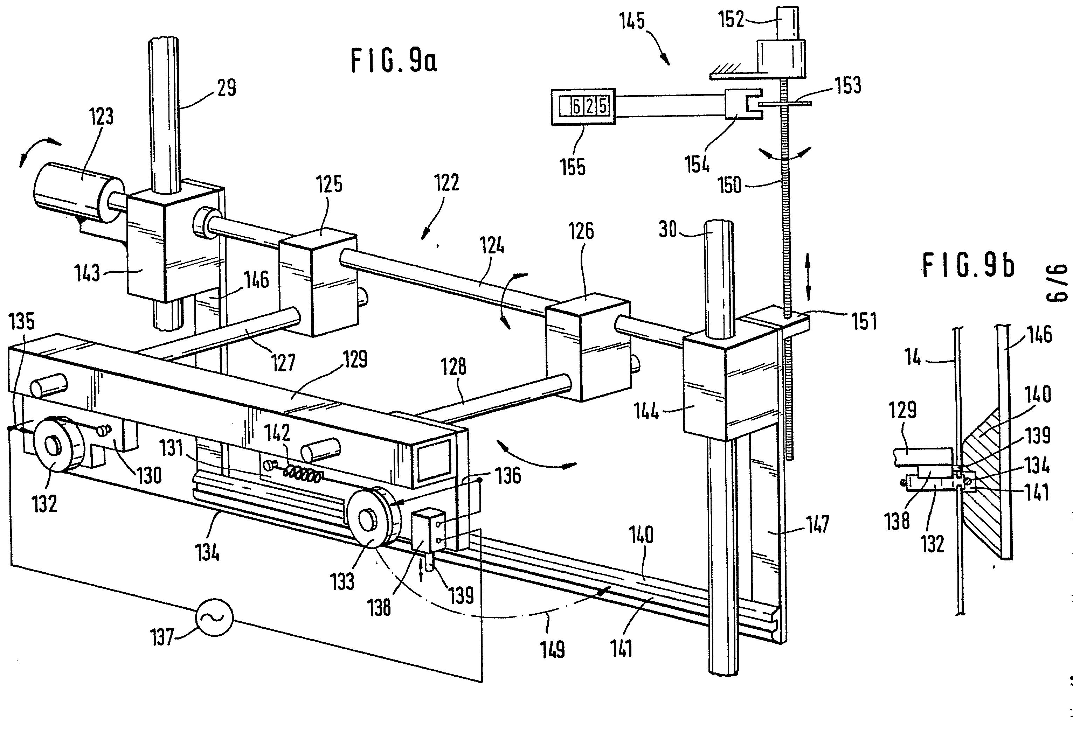

Die Figuren 9a und 9b zeigen eine Schneideinrichtung 122 mit einem beheizten Schneiddraht 134 für den Fotoresistfilm 14, die beispielsweise anstelle der Schneideinrichtung 15 (vgl. Fig. 1 und 4) mit dem rotierenden Messer eingesetzt wird. Es entfallen dann die der Schneideinrichtung 15 zugeordneten Teile, wie der Motor 16, Querträger 33, Klemmstück 34, Messerträger 35, Getriebe 36, Kurvenrolle 37, Kurvenstück 38, Zahnstange 72 und die Winkelarme 73 der Ausführungsform, die in Fig. 4 dargestellt ist.

Die Schneideinrichtung 122 ist um eine Schwenkachse 124, die ein Motor 123 betätigt, schwenkbar. Die Schwenkachse 124 ist in Führungen 143,144 gelagert, die durch eine Positioniervorrichtung 145 entlang den Führungsstangen 29,30 auf und ab verfahrbar und in einer vorwählbaren Stellung festlegbar sind. Auf der Schwenkachse 124 sitzen zwei Lagerblöcke 125,126 auf, in denen je ein Lagerarm 127 bzw. 128 gelagert ist, der den Lagerblock mit einem Ende durchsetzt. Die Lagerarme erstrecken sich mit ihren anderen Enden durch einen Träger 129, beispielsweise ein hohles Vierkantrohr, das an der Unterseite Befestigungsteile 130,131 für Kugellager 132,133 trägt, über die der beheizte Schneiddraht 134 geführt ist. Das eine Ende des Schneiddrahts ist ortsfest angebracht, während das

E L T I Apparatebau und Elektronik GmbH
und
H O E C H S T   A K T I E N G E S E L L S C H A F T
KALLE  Niederlassung der Hoechst AG

0163315

- 30 -

andere Ende mit einer Feder 142 verbunden ist, die an dem Befestigungsteil 131 angebracht ist. Die Feder 142 hält den Schneiddraht 134 stets gestrafft. Das Erwärmen des Schneiddrahts 134 erfolgt durch eine Stromquelle 137, deren einer Pol über einen Schleifkontakt 135 mit dem ersten Kugellager 132 in Kontakt steht. Der andere Pol der Stromquelle 137, die z.B. eine Wechsel- oder eine Gleichstromquelle sein kann, ist an einem Anschluß eines Mikroschalters 138 angeschlossen, dessen anderer Anschluß über den Schleifkontakt 136 mit dem zweiten Kugellager 133 in Verbindung steht. An den unteren Enden von Halterungen 146,147, die an den Führungen 143,144 befestigt sind und sich von diesen nach unten erstrecken, ist eine Auflageschiene 140 horizontal befestigt, die einen durchgehenden Schlitz 141 in einem Körper mit beispielsweise trapezförmigem Querschnitt aufweist.

Die Positioniervorrichtung 145 für die Schneideinrichtung 122 besteht beispielsweise aus einer Spindel 150, die mit einer Spindelmutter 151 im Eingriff steht, die an der Rückseite der einen Führung 144 angeordnet ist. Ein Spindelmotor 152 versetzt die Spindel 150 nach Bedarf im Uhrzeiger- oder Gegenuhrzeigersinn in Drehung. Auf der Spindel 150 ist eine Scheibe 153 befestigt, die beispielsweise als Schlitz- oder Lochscheibe ausgebildet ist und eine Lichtschranke 154 durchläuft. Bei jeder ganzen Umdrehung der Spindel bzw. jedem vollen Durchgang der Scheibe 153 durch die Lichtschranke 154 erzeugt diese einen Puls, der in einem an die

E  L  T  I  Apparatebau und Elektronik GmbH
und
H O E C H S T   A K T I E N G E S E L L S C H A F T
KALLE  Niederlassung der Hoechst AG

- 31 -

Lichtschranke angeschlossenen Zähler 155 angezeigt wird. Die Ganghöhe der Spindel 150 kann beispielsweise so gewählt werden, daß einer vollen Umdrehung der Spindel 150 eine Verschiebung der Schneideinrichtung 122 um einen Millimeter entlang den Führungsstangen 29,30 nach oben oder unten entspricht und die Zahlenanzeige des Zählers 155 zeigt dann die jeweilige Position der Schneideinrichtung, d.h. die Entfernung in Millimetern von einer Ausgangs- oder Startposition an. Zu Beginn jedes neuen Positioniervorgangs wird die Schneideinrichtung 122 automatisch in ihre Startposition verfahren, von der aus dann die neue Position angefahren wird.

Selbstverständlich sind auch andere, dem Fachmann geläufige Positioniervorrichtungen für die Schneideinrichtung geeignet.

Fig. 9b zeigt schematisch in Schnittansicht die Schneideinrichtung 122 während des Durchschneidens des Fotoresistfilms 14. Der Träger 129 mit dem Schneiddraht 134 wird für den Schnittvorgang durch den Motor 123 entlang der Bahn 149 in Richtung der Auflageschiene 140 für den Fotoresistfilm 14 verschwenkt und der Schneiddraht 134 durchtrennt beim Eintreten in den Schlitz 141 der Auflageschiene 140 den auf der Auflageschiene aufliegenden Fotoresistfilm 14.

In der Schnittstellung des Schneiddrahts 134 liegt eine Schaltfahne 139 des Mikroschalters 138 an der

E  L  T  I  Apparatebau und Elektronik GmbH
und
H O E C H S T   A K T I E N G E S E L L S C H A F T
KALLE  Niederlassung der Hoechst AG

- 32 -

Auflageschiene 140 an, so daß der Mikroschalter 138 geschaltet und die Stromversorgung des Schneiddrahts 134 unterbrochen wird. Dadurch wird erreicht, daß es beim Zurückschwenken des Schneiddrahtes 134 in die Stellung nach Fig. 9a nicht zu einem Festkleben der Schnittkante des Fotoresistfilms an dem abgekühlten Schneiddraht kommt, der beim Zurückschwenken streifend über die Schnittkante geführt wird. Ohne Abschalten der Beheizung des Schneiddrahts ist dieser so heiß, daß bei seinem Zurückschwenken in die Ausgangslage die Gefahr seines Anklebens an dem Fotoresistfilm beim streifenden Passieren der Schnittkante gegeben wäre. Der Schneiddraht 134 ist zweckmäßigerweise von einer Abschirmung umgeben, die aus Gründen der besseren Übersichtlichkeit in der Zeichnung weggelassen wurde.

- - -

E L T I Apparatebau und Elektronik GmbH
und
H O E C H S T   A K T I E N G E S E L L S C H A F T
KALLE  Niederlassung der Hoechst AG

84/K 753            - 33 -            21. Mai 1985
                                     WLK-DI.Z.-is

0163315

P a t e n t a n s p r ü c h e

1. Verfahren zum Laminieren eines Films unter Druck und Wärme auf die sich gegenüberliegenden Seiten eines Schichtträgers, dessen beiden Seiten erwärmt sind, gekennzeichnet durch folgende Schritte:

(a) der Schichtträger wird in waagerechter Lage beidseitig flächendeckend beheizt,

(b) eine vorbestimmte Länge des Films wird von einer einzelnen Vorratsrolle abgezogen, senkrecht über die Oberseite von vertikal ausgerichteten Vakuumtische und einer dazwischen befindlichen Laminierstation geführt und mit Hilfe der Vakuumtische senkrecht aufgespannt,

(c) der Film wird im Bereich zwischen der oberen Kante des über der Laminierstation angeordneten Vakuumtisches und der Laminierstation durchschnitten,

(d) der aufgeheizte, waagerecht transportierte Schichtträger wird auf den senkrecht aufgespannten Film in Höhe der Laminierstation geführt,

(e) der Schichtträger zieht beim Einschieben in die Laminierstation den Film in den Spalt zwischen zwei Laminierwalzen, die rotieren und den Verbund aus Schichtträger und dem sich gleichzeitig auf die sich gegenüberliegenden Seiten des Schichtträgers

E  L  T  I  Apparatebau und Elektronik GmbH
und
H O E C H S T   A K T I E N G E S E L L S C H A F T
KALLE  Niederlassung der Hoechst AG

- 34 -

anlegenden Film horizontal hindurchtransportieren, wobei der Film unter Druckkontakt auf die beiden Seiten des Schichtträgers laminiert wird.

2. Verfahren nach Anspruch 1, dadurch gekennzeichnet, daß auf die Oberflächen des Schichtträgers vor dem Laminieren des Films eine Flüssigkeitsschicht aufgetragen wird.

3. Verfahren nach Anspruch 1, dadurch gekennzeichnet, daß vor dem Laminieren eine Flüssigkeitsschicht auf die Seite des Films aufgetragen wird, die sich an die beiden Seiten des Schichtträgers während des Laminierens anlegt und auf diesen Seiten nach dem Laminieren haftet.

.4. Verfahren nach Anspruch 1 oder 2, dadurch gekennzeichnet, daß die Flüssigkeitsschicht aus einer Mischung aus destilliertem Wasser und Methanol, Ethanol oder Fluorkohlenstofflösungen von Alkoholen besteht.

5. Verfahren nach Anspruch 1, dadurch gekennzeichnet, daß der Schichtträger auf eine Temperatur zwischen 70° und 120 °C erwärmt, danach in Richtung Laminierstation transportiert, vor dem Eintritt in die Laminierstation ausgerichtet, danach ergriffen und soweit auf die Laminierstation zubewegt wird, daß seine Vorderkante von den rotierenden Laminierwalzen erfaßt wird.

E L T I Apparatebau und Elektronik GmbH
und
H O E C H S T   A K T I E N G E S E L L S C H A F T
KALLE   Niederlassung der Hoechst AG

- 35 -

6. Verfahren nach Anspruch 5, dadurch gekennzeichnet, daß der ergriffene Schichtträger freigegeben und geführt wird, sobald seine Vorderkante von den rotierenden Laminierwalzen weitertransportiert wird.

7. Verfahren nach Anspruch 1, dadurch gekennzeichnet, daß der bandförmige Film über seine volle Breite streifenförmig ergriffen und senkrecht nach unten über die Laminierstation hinweg eine vorgegebene Länge transportiert wird.

8. Verfahren nach Anspruch 7, dadurch gekennzeichnet, daß das Ergreifen und Festhalten des Films während des Transports mittels Vakuum erfolgt.

9. Verfahren nach Anspruch 7, dadurch gekennzeichnet, daß der Film mechanisch ergriffen und von der Vorratsrolle abgezogen wird.

10. Vorrichtung zur Durchführung des Verfahrens nach den Ansprüchen 1 bis 9, mit einer Vorratsrolle aus Fotoresist als Film, einem Magazin für die Aufnahme der zu laminierenden Schichtträger, einer Heizstation für die Schichtträger, einer Laminierstation aus zwei Laminierwalzen und Vakuumtischen zum Aufspannen des Fotoresists sowie einer Schneideinrichtung zum Schneiden des Fotoresists, dadurch gekennzeichnet, daß der Schichtträger (3) horizontal über eine Rollenbahn (66) durch eine Heizstation (4,104), eine seitliche Ausrichteinrichtung (91) und einen Plattengreifer (43) hin-

E L T I Apparatebau und Elektronik GmbH
und
H O E C H S T  A K T I E N G E S E L L S C H A F T
KALLE  Niederlassung der Hoechst AG

- 36 -

durchläuft und mit der Vorderkante an einem Parallelanschlag (39) zum Anliegen kommt, der in die Rollenbahn (66) einschwenkbar und aus dieser ausschwenkbar ist, daß oberhalb und unterhalb der Laminierstation (9) je ein Vakuumtisch (17,18) mit vertikaler Saugplatte (17',18') angeordnet ist und daß eine Greiferleiste (20) einen streifenförmigen Abschnitt des Fotoresistfilms (14) ergreift und entlang zueinander paralleler, vertikaler Führungsstangen (29,30) vertikal nach unten aus einer einstellbaren Stellung oberhalb der Laminierstation (9), über die Laminierstation hinweg bis in eine Stellung im Bereich des unteren Vakuumtisches (18) verfährt.

11. Vorrichtung nach Anspruch 10, dadurch gekennzeichnet, daß zwischen der Heizstation (4) und der Laminierstation (9) Auftragseinrichtungen (62,63) zum Aufbringen einer Flüssigkeitsschicht auf der Ober- und Unterseite des horizontal transportierten Schichtträgers (3) angeordnet sind.

12. Vorrichtung nach Anspruch 10, dadurch gekennzeichnet, daß eine Auftragseinrichtung (60) zum Aufbringen einer Flüssigkeitsschicht auf der Vorderseite des über die Vakuumtische (17,18) nach unten transportierten Fotoresistfilms (14) nahe der Umlenkrolle (8) für den Fotoresistfilm angeordnet ist.

13. Vorrichtung nach Anspruch 9, dadurch gekennzeichnet, daß ein Motor (5) die Umlenkrolle (8) antreibt,

E L T I Apparatebau und Elektronik GmbH
und
H O E C H S T   A K T I E N G E S E L L S C H A F T
KALLE Niederlassung der Hoechst AG

0163315

- 37 -

die als Transportrolle für den Fotoresistfilm (14)
dient, wenn dieser von einer Vorratsrolle (13) abgezogen wird.

14. Vorrichtung nach Anspruch 13, dadurch gekennzeichnet, daß eine Andruck- und Trennrolle (7) für
eine Schutzfolie (80), die abziehbar auf dem Fotoresistfilm (14) haftet, an der Umlenkrolle (8) anliegt
und daß die Schutzfolie (80) über die Andruck- und
Trennrolle (7) auf eine Aufnahmerolle (6) aufwickelbar
ist.

15. Vorrichtung nach Anspruch 13, dadurch gekennzeichnet, daß die Vorratsrolle (13) in einem Schwenkrahmen (78) gelagert ist, der um eine Vertikalachse
horizontal verschwenkbar ist.

16. Vorrichtung nach Anspruch 13, dadurch gekennzeichnet, daß auf der Welle der Umlenkrolle (8) ein
Kettenrad (25) aufsitzt, um das eine endlose Antriebskette (26) geführt ist, die um ein weiteres Kettenrad
(28) herumgeführt ist, und daß ein auf einer Führung
(22) der Greiferleiste (20) befestigter Kettenanschluß
(27) mit der Antriebskette (26) kraftschlüssig verbunden ist.

17. Vorrichtung nach Anspruch 16, dadurch gekennzeichnet, daß die Greiferleiste (20) eine weitere Führung (21) aufweist und daß die Greiferleiste (20) zusammen mit den beiden Führungen (20,21) mittels der

E L T I Apparatebau und Elektronik GmbH
und
H O E C H S T   A K T I E N G E S E L L S C H A F T
KALLE  Niederlassung der Hoechst AG

- 38 -

umlaufenden Antriebskette (26) entlang den vertikalen Führungsstangen (29,30) verfahrbar ist.

18. Vorrichtung nach Anspruch 17, dadurch gekennzeichnet, daß die Greiferleiste (20) eine Vakuumleiste ist, die über eine flexible Vakuumleitung (69) mit einer Vakuumpumpe (24) verbunden ist.

19. Vorrichtung nach Anspruch 10, dadurch gekennzeichnet, daß ein Messerträger (35) mit einer Zahnstange (72) an Führungen (31,32) schwenkbar gelagert ist, die durch einen Querträger (33) miteinander verbunden und entlang den Führungsstangen (29,30) mittels eines Klemmstücks (34) bzw. einer elektrischen Positioniereinrichtung vertikal verschieb- und feststellbar sind.

20. Vorrichtung nach Anspruch 19, dadurch gekennzeichnet, daß ein Getriebe (36) mit der Zahnstange (72) im Eingriff steht, von einem Motor (16) angetrieben und über die Breite des Fotoresistfilms (14) verfahrbar ist und daß das Getriebe (36) die mit ihm verbundene Schneideinrichtung (15) in Gestalt eines Rotationsmessers zum Schneiden des Fotoresistfilms in Drehung versetzt.

21. Vorrichtung nach den Ansprüchen 19 und 20, dadurch gekennzeichnet, daß an dem Querträger (33) und parallel dazu in einem vorgegebenen Abstand verlaufend eine Schiene (19) mit Schneidkante angebracht ist,

E L T I Apparatebau und Elektronik GmbH
und
H O E C H S T  A K T I E N G E S E L L S C H A F T
KALLE  Niederlassung der Hoechst AG

- 39 -

entlang der die Schneideinrichtung (15) über den Fotoresistfilm während des Schneidens bewegt wird.

22. Vorrichtung nach Anspruch 19, dadurch gekennzeichnet, daß an dem Messerträger (35) ein Winkelarm
(73) angeordnet ist, der an seinem freien Ende eine
Kurvenrolle (37) trägt, die mit einem Kurvenstück
(38), das an der einen Führung (21) der Greiferleiste
(20) befestigt ist, beim Hochfahren der Greiferleiste
(20) in Berührung gelangt und auf dem Kurvenstück (38)
abrollt, um den Winkelarm (73) und den Messerträger
(35) zusammen mit der Schneideinrichtung (15) von dem
Fotoresistfilm (14) abzuheben.

23. Vorrichtung nach Anspruch 10, dadurch gekennzeichnet, daß der Parallelanschlag (39) an zwei Winkelhebeln (57,57) befestigt ist, die ein zylindrischer
Verbindungsträger (59) miteinander verbindet, und daß
die über die Winkelhebel (57,57) hinaus verlängerte
Achse des Verbindungsträgers (59) in Lagern (41,41)
drehbar gelagert ist.

24. Vorrichtung nach Anspruch 23, dadurch gekennzeichnet, daß an dem Verbindungsträger (59) eine
Platte (58) befestigt ist, an der ein Betätigungszylinder (42) angreift, um den Parallelanschlag (39) in
die und aus der Bahn des Schichtträgers (3) zu
schwenken.

E L T I Apparatebau und Elektronik GmbH
und
H O E C H S T   A K T I E N G E S E L L S C H A F T
KALLE  Niederlassung der Hoechst AG

0163315

- 40 -

25. Vorrichtung nach Anspruch 23, dadurch gekennzeichnet, daß an dem Parallelanschlag (39) zwei horizontal verschwenkbare Führungsröllchen (40,40) angeordnet sind, die sich an die Längskanten des Schichtträgers (3) anlegen, wenn dessen Vorderkante an dem Parallelanschlag (39) anliegt und ausgerichtet wird.

26. Vorrichtung nach Anspruch 10, dadurch gekennzeichnet, daß der Plattengreifer (43) zwei horizontale, übereinanderliegende Klemmbacken (67,68) aufweist, zwischen denen Federn (44,44), welche Zugstangen (45,46) umgeben, zum Öffnen des Plattengreifers (43) angeordnet sind, dessen obere Klemmbacke (67) ein Zylinder (49) vertikal nach unten gegen die Druckkraft der Federn (44,44) bis zum Anliegen an der Oberseite des Schichtträgers (3) und zum Ergreifen des Schichtträgers zieht.

27. Vorrichtung nach Anspruch 26, dadurch gekennzeichnet, daß die Zugstangen (45,46), die in Führungen (47,48) laufen und die Klemmbacken (67,68) durchsetzen, mit einer Querstrebe (74) des Plattengreifers (43) verbunden und mit Flügelmuttern (88,89) oberhalb der oberen Klemmbacke (67) verschraubt sind, und daß der Zylinder (49) an der Querstrebe (74) befestigt ist.

28. Vorrichtung nach Anspruch 26, dadurch gekennzeichnet, daß an einem Träger (50) des Plattengreifers (43), der unterhalb der Klemmbacken (67,68) des Plat-

E L T I Apparatebau und Elektronik GmbH
und
H O E C H S T   A K T I E N G E S E L L S C H A F T
KALLE  Niederlassung der Hoechst AG

- 41 -

tengreifers angeordnet ist, zwei zueinander parallele, horizontal durch Führungslager (51,51) verlaufende Führungsstangen (52,53) befestigt sind und daß ein Betätigungszylinder (54) an dem Träger (50) angreift und den Plattengreifer (43) waagerecht hin- und herverfährt.

29. Vorrichtung nach den Ansprüchen 10 und 25, dadurch gekennzeichnet, daß vor der Rollenbahn (66), in Transportrichtung des Schichtträgers (3) gesehen, ein umklappbarer Transportfinger (55) angeordnet ist, den ein Zylinder (56) an die Hinterkante des Schichtträgers (3) anlegt und zum Ausrichten der Vorderkante des Schichtträgers an dem Parallelanschlag (39) vorwärts schiebt und anschliessend in die Ausgangsstellung zurückbewegt.

30. Vorrichtung nach Anspruch 10, dadurch gekennzeichnet, daß die Saugplatte (17';18') des Vakuumtisches (17;18) zeilen- und reihenweise angeordnete Formbohrungen (95,95,...) aufweist, die über Bohrungen (98,98,...) mit dem Inneren des Vakuumtisches (17;18) verbunden sind und die von Nuten (96,96,...; 97,97,..., 100,100,...), die keinen Anschluß an Vakuum haben, umgeben sind.

31. Vorrichtung nach Anspruch 30, dadurch gekennzeichnet, daß die Formbohrungen (95,95,...) kalottenförmige Vertiefungen in der Saugplatte (17';18'), mit einem Durchmesser der Formbohrungen in der Ebene der Saugplattenoberfläche zwischen 10 und 20 mm sind.

E L T I Apparatebau und Elektronik GmbH
und
H O E C H S T   A K T I E N G E S E L L S C H A F T
KALLE Niederlassung der Hoechst AG

0163315

- 42 -

32. Vorrichtung nach Anspruch 30, dadurch gekennzeichnet, daß die Nuten ein Netz aus zwei aufeinander senkrecht stehenden Gitterscharen (96,96,...; 97,97,...) bilden und daß der Abstand der Mittellinien zweier benachbarter paralleler Nuten 15 bis 25 mm beträgt.

33. Vorrichtung nach Anspruch 32, dadurch gekennzeichnet, daß zwischen dem Rand der einzelnen Formbohrung und den umgebenden Nuten ein Steg von 1 bis 1,5 mm Stärke an der engsten Stelle besteht.

34. Vorrichtung nach Anspruch 30, dadurch gekennzeichnet, daß in jeder Formbohrung (95,95,...) ein kreuzförmiger Steg (96) angeordnet ist, dessen Oberkanten mit der Oberfläche der Saugplatte (17';18') abschließen.

.35. Vorrichtung nach Anspruch 31, dadurch gekennzeichnet, daß die Nuten (100,100,...) kreisringförmig die Formbohrungen (95,95,...) umgeben, daß zwischen dem Rand der einzelnen Formbohrung und der umgebenden Nut ein kreisförmiger Steg (101) von 1 bis 1,5 mm Stärke vorhanden ist und daß benachbarte Nuten im Bereich der stärksten Annäherung der zugehörigen Formbohrungen einander überschneiden.

36. Vorrichtung nach Anspruch 10, dadurch gekennzeichnet, daß auf der Saugplatte (17';18') des Vakuumtisches (17;18) eine Lochplatte (102) mit gleichgroßen rechteckförmigen oder quadratischen Durchbrüchen (103) befestigt ist, die reihen- und zeilenförmig so angeordnet

E L T I Apparatebau und Elektronik GmbH
und
H O E C H S T  A K T I E N G E S E L L S C H A F T
KALLE  Niederlassung der Hoechst AG

- 43 -

und dimensioniert sind, daß jeweils vier Durchbrüche
über einer der Formbohrungen (95) in der Saugplatte
(17';18') liegen.

37. Vorrichtung nach Anspruch 10, dadurch gekennzeichnet, daß eine Heizvorrichtung (104) zwei endlos
horizontal umlaufende Transportbänder (105;106) aufweist, die jeweils über zwei Rollen (107,108 bzw.
109,110) geführt sind, daß die Transportbänder miteinander im Druckkontakt sind und einen sich in Transportrichtung des Schichtträgers (3) verengenden Spalt
(117) bilden, der vor dem planen Berührungsbereich der
Transportbänder liegt.

38. Vorrichtung nach Anspruch 37, dadurch gekennzeichnet, daß jedes der Transportbänder (106,106) in
Kontakt mit einem Elektroheizkörper (113,115) ist, daß
der untere Elektroheizkörper (113) lagefest und der
obere Elektroheizkörper (115) federnd aufgehängt ist
und daß die Elektroheizkörper (113,115) einander gegenüberliegen.

39. Vorrichtung nach Anspruch 37, dadurch gekennzeichnet, daß das obere Transportband (105) von einem
Gehäuse (119) umgeben ist, dessen Deckfläche (120)
über die eine Seitenfläche des Gehäuses (119) hinaus
verlängert und in einem Kipplager (121) gelagert ist.

40. Vorrichtung nach Anspruch 37, dadurch gekennzeichnet, daß das untere Transportband (106) von einem

0163315

- 44 -

lagefesten Gehäuse (118) umgeben ist, daß die hintere Rolle eine Antriebsrolle (110) ist, die ein Motor (111) antreibt und daß das untere Transportband das obere Transportband (105) durch Reibung mitnimmt und in Umlauf versetzt.

41. Vorrichtung nach Anspruch 10, dadurch gekennzeichnet, daß eine Schneideinrichtung (122) um eine Schwenkachse (124) durch einen Motor (123) schwenkbar ist und daß die Schwenkachse (124) in Führungen (143,144) gelagert ist, die durch eine Positioniervorrichtung (145) entlang Führungsstangen (29,30) auf und ab verfahrbar sind.

42. Vorrichtung nach Anspruch 41, dadurch gekennzeichnet, daß die Schneideinrichtung einen Schneiddraht (134) aufweist, der über zwei Kugellager (132,133) geführt ist und den eine Stromquelle (137) beheizt.

43. Vorrichtung nach Anspruch 42, dadurch gekennzeichnet, daß das eine Ende des Schneiddrahts (134) ortsfest an einem ersten Befestigungsteil (130) angebracht ist, der das eine Kugellager (132) trägt und daß das andere Ende des Schneiddrahts mit einer, an einem zweiten Befestigungsteil (131) für das andere Kugellager (133) befestigten Feder (142) zum Spannen des Schneiddrahts verbunden ist.

44. Vorrichtung nach Anspruch 41, dadurch gekenn-

E L T I Apparatebau und Elektronik GmbH
und
H O E C H S T   A K T I E N G E S E L L S C H A F T
KALLE  Niederlassung der Hoechst AG

0163315

- 45 -

zeichnet, daß auf der Schwenkachse (124) zwei Lagerblöcke (125,126) aufsitzen, durch die sich Lagerarme (127,128) erstrecken, die mit ihren von der Schwenkachse abgewandten Enden einen Träger (129) durchsetzen, an dessen Unterseite die Befestigungsteile (130,131) angebracht sind.

45. Vorrichtung nach Anspruch 42, dadurch gekennzeichnet, daß der eine Pol der Stromquelle (137) über einen Schleifkontakt (135) mit dem einen Kugellager (132) und der andere Pol über einen Mikroschalter (138) und einen mit diesem in Reihe geschalteten Schleifkontakt (136) mit dem anderen Kugellager (133) in Verbindung steht.

46. Vorrichtung nach Anspruch 41, dadurch gekenn-zeichnet, daß an Halterungen (146,147), die an den Führungen (143,144) befestigt sind, eine Auflageschiene (140) für den Fotoresistfilm (14) horizontal angebracht ist, die einen durchgehenden Schlitz (148) aufweist, in den der Schneiddraht (134) nach dem Durchschneiden des die Auflageschiene (140) überspannenden Fotoresistfilms (14) eintritt.

47. Vorrichtung nach den Ansprüchen 45 und 46, dadurch gekennzeichnet, daß in der Schnittposition des Schneiddrahts (134) eine Schaltfahne (139) des Mikroschalters (138) an der Auflageschiene (140) anliegt, diesen schaltet und die Stromversorgung des Schneid-drahts (134) unterbricht.

E  L  T  I  Apparatebau und Elektronik GmbH
und
H O E C H S T   A K T I E N G E S E L L S C H A F T
KALLE  Niederlassung der Hoechst AG

- 46 -

48.  Vorrichtung nach Anspruch 41, dadurch gekennzeichnet, daß die Positioniervorrichtung (145) aus
einer Spindel (150), die mit einer Spindelmutter (151)
im Eingriff ist, einem die Spindel (150) in Drehung
versetzenden Spindelmotor (152), einer auf der Spindel
aufsitzenden Loch- oder Schlitzscheibe (153) und einer
Lichtschranke (154) besteht.

49.  Vorrichtung nach Anspruch 48, dadurch gekennzeichnet, daß die Loch- oder Schlitzscheibe (153) mit
ihrem Rand in die Lichtschranke (154) hineinragt, die
an einem Zähler (155) angeschlossen ist, der jede
Spindelumdrehung digital anzeigt.

---

0163315

FIG.1

ELTI Apparatebau und Elektronik GmbH

und HOECHST AKTIENGESELLSCHAFT

84/K 7 5 3

# FIG. 2

FIG.3

0163315

**FIG.4**

0163515

FIG. 5

FIG. 6

ELTI Apparatebau und Elektronik GmbH
und
HOECHST AKTIENGESELLSCHAFT
84/K 753

0163315

## FIG. 7a

## FIG.7b

ELTI Apparatebau und Elektronik GmbH
und    HOECHST AKTIENGESELLSCHAFT
84/K 7 5 3

0163315

FIG. 7c

FIG. 7d

ELTI Apparatebau und Elektronik GmbH
und HOECHST AKTIENGESELLSCHAFT
84/K 7 5 3

0163315

# FIG. 8

ELTI Apparatebau und Elektronik GmbH
und HOECHST AKTIENGESELLSCHAFT
84/K 7 5 3

FIG.9a

FIG.9b